# EUROPEAN PATENT APPLICATION

(11) **EP 4 528 807 A1**
(43) Date of publication of application: **26.03.2025**
(21) Application number: 23306539.0
(22) Date of filing: 19.09.2023
(51) Int. Cl.: H01L 23/482, H01L 23/66

(54) **RF AMPLIFIERS WITH INTRINSIC HARMONIC TERMINATION AND/OR MULTISTAGE IMPEDANCE MATCHING**

(71) Applicant: Wolfspeed, Inc., Durham, NC 27703 (US)
(72) Inventor: BOUISSE, Gerard, 31470 Saint-Lys (FR); FISHER, Jeremy, Raleigh, 27614 (US)
(74) Representative: Boult Wade Tennant LLP

(57) **Abstract**

A radio frequency transistor amplifier includes a transistor die comprising a semiconductor structure including a plurality of transistors and input, output, and ground connections electrically coupled thereto, and one or more impedance adjustment elements that are internal to and/or extend external to the semiconductor structure. The one or more impedance adjustment elements are electrically coupled to the ground connection, and are configured to provide impedance matching and/or harmonic termination at the input and/or output connections at an operating frequency of the RF transistor amplifier. Related devices and fabrication methods are also discussed.

## Description

### FIELD

The present disclosure relates to transistor devices, and more particularly, to transistor amplifier devices.

### BACKGROUND

Electrical circuits requiring high power handling capability while operating at high frequencies, such as radio frequency ("RF") operating ranges of 0.5-1 GHz, 3 GHz, and 10 GHz or more, have in recent years become more prevalent. In particular, there is now a high demand for radio frequency RF power amplifiers that are used to amplify RF signals at radio (including microwave) frequencies in a variety of applications, such as base stations for wireless communication systems, etc. The signals amplified by the RF power amplifiers often include signals that have a modulated carrier having frequencies in the megahertz (MHz) to gigahertz (GHz) range. These RF power amplifiers may need to exhibit high reliability, good linearity, and handle high output power levels.

Many RF power amplifier designs utilize semiconductor switching devices as amplification devices. Examples of these switching devices include power transistor devices, such as field effect transistor (FET) devices including MOSFETs (metal-oxide semiconductor field-effect transistors), DMOS (double-diffused metal-oxide semiconductor) transistors, HEMTs (high electron mobility transistors), MESFETs (metal-semiconductor field-effect transistors), LDMOS (laterally-diffused metal-oxide semiconductor) transistors, etc.

RF transistor amplifiers are typically formed as semiconductor integrated circuit chips. Most RF transistor amplifiers are implemented in silicon or using wide bandgap semiconductor materials (i.e., having a band-gap greater than 1.40 eV), such as silicon carbide ("SiC") and Group III nitride materials. As used herein, the term "Group III nitride" refers to those semiconducting compounds formed between nitrogen and the elements in Group III of the periodic table, usually aluminum (Al), gallium (Ga), and/or indium (In). The term also refers to ternary and quaternary compounds, such as AlGaN and AlInGaN. These compounds have empirical formulas in which one mole of nitrogen is combined with a total of one mole of the Group III elements.

RF transistor amplifiers may include one or more amplification stages, with each stage typically implemented as a transistor amplifier. In order to increase the output power and current handling capabilities, RF transistor amplifiers are typically implemented in a "unit cell" configuration in which a large number of individual "unit cell" transistor structures are arranged electrically in parallel. An RF transistor amplifier may be implemented by transistor unit cells of a single integrated circuit chip or "die," or may include a plurality of dies. A die or chip may refer to a small block of semiconducting material or other substrate on which electronic circuit elements are fabricated. When multiple RF transistor amplifier dies are used, they may be connected in series and/or in parallel.

Silicon-based RF transistor amplifiers are typically implemented using LDMOS transistors, and can exhibit high levels of linearity with relatively inexpensive fabrication. Group III nitride-based RF amplifiers are typically implemented using HEMTs, primarily in applications requiring high power and/or high frequency operation where LDMOS transistor amplifiers may have inherent performance limitations.

In operation of HEMT devices, a two-dimensional electron gas (2DEG) is formed at the heterojunction of two semiconductor materials with different bandgap energies, where the smaller bandgap material has a higher electron affinity. The 2DEG is an accumulation layer in the smaller bandgap material and can contain a very high sheet electron concentration. Additionally, electrons that originate in the wider-bandgap semiconductor material transfer to the 2DEG layer, allowing high electron mobility due to reduced ionized impurity scattering. This combination of high carrier concentration and high carrier mobility can give the HEMT a very large transconductance and may provide a strong performance advantage over metal oxide semiconductor field effect transistors (MOSFETs) for high-frequency applications. High electron mobility transistors fabricated in Group III-nitride based material systems also have the potential to generate large amounts of radio frequency (RF) power because of the combination of material characteristics that includes the aforementioned high breakdown fields, wide bandgaps, large conduction band offset, and/or high saturated electron drift velocity.

RF transistor amplifiers often include matching circuits or circuitry, such as (i) impedance matching circuits that are designed to improve the impedance match between the active transistor die (e.g., including MOSFETs, HEMTs, LDMOS, etc.) and transmission lines connected thereto for RF signals at the fundamental operating frequency (f0), and (ii) harmonic termination circuits that are designed to at least partly terminate harmonics of the fundamental frequency f0 (also referred to herein as harmonic products) that may be generated during device operation, such as second order (2f0) and third order (3f0) harmonics. The termination of the harmonic products also influences generation of baseband intermodulation distortion products.

The transistor die(s) as well as the impedance matching and harmonic termination circuits may be enclosed in a device package. Integrated circuit packaging may refer to encapsulating one or more dies in a supporting case or package that protects the dies from physical damage and/or corrosion, and supports the electrical contacts for connection to external circuits. Electrical leads may extend from the package to electrically connect the transistor die to external systems and/or circuit elements such as input and output RF transmission lines and bias voltage sources. The impedance matching and harmonic termination circuitry in an integrated circuit device package typically include inductor-capacitor (LC) networks configured to match the impedance of the active transistor die to a fixed value. Typically, the impedance matching and harmonic termination circuitry employs off-die components and implementations, which may increase the package footprint and/or parasitic inductance between components.

### SUMMARY

According to some embodiments of the present disclosure, a radio frequency (RF) transistor amplifier includes a transistor die comprising a semiconductor structure including a plurality of transistors and input, output, and ground connections electrically coupled thereto. The transistor die comprises one or more impedance adjustment elements that are internal to the semiconductor structure, are electrically coupled to the ground connection, and are configured to provide harmonic termination at the input and/or output connections at an operating frequency of the RF transistor amplifier.

In some embodiments, the plurality of transistors comprise gate, drain, and source fingers that are electrically coupled to the input, output, and ground connections, respectively, and the one or more impedance adjustment elements comprise one or more conductive vias on a respective source finger.

In some embodiments, the transistor die further comprises a gate bus that electrically couples the gate fingers, and a drain bus that electrically couples the drain fingers; and the one or more conductive vias comprise at least one first via proximate the gate bus and configured to provide the harmonic termination at the input connection, and/or at least one second via proximate the drain bus and configured to provide the harmonic termination at the output connection.

In some embodiments, the one or more impedance adjustment elements are configured to provide the harmonic termination at the input and/or output connections based on at least one of: a quantity of the one or more conductive vias on the respective source finger; respective locations of the one or more conductive vias on the respective source finger, relative to the gate bus or the drain bus; or a unit gate width of the gate fingers.

In some embodiments, the one or more impedance adjustment elements are configured to provide a short circuit condition at the input connection and/or at the output connection of the transistor die at one or more harmonic frequencies of the operating frequency.

In some embodiments, the one or more impedance adjustment elements are configured to provide the short circuit condition at the input connection at a second harmonic frequency of the operating frequency, and are configured to provide the short circuit condition at the output connection at a third harmonic frequency of the operating frequency.

In some embodiments, the one or more impedance adjustment elements are configured to provide the short circuit condition free of contributions from harmonic termination circuit elements that are external to the semiconductor structure of the transistor die.

In some embodiments, the one or more impedance adjustment elements are not connected to the input and/or output connections.

In some embodiments, a package substrate includes input, output, and ground terminals, and the transistor die is on the package substrate and the ground terminal of the package substrate is electrically coupled to the ground connection of the transistor die.

In some embodiments, the transistor die is mounted on a surface of the package substrate in a flip chip configuration with the input, output, and ground connections adjacent the surface of the package substrate.

In some embodiments, the package substrate is free of harmonic termination circuit elements that are coupled to the input and/or output connections.

In some embodiments, a unit gate width of the gate fingers is based on the operating frequency.

In some embodiments, the operating frequency is below about 12 GHz, or is below about 6 GHz.

In some embodiments, the semiconductor structure comprises gallium nitride and/or silicon carbide.

According to some embodiments, radio frequency (RF) transistor amplifier includes a transistor die comprising a semiconductor structure including a plurality of transistors and input, output, and ground connections electrically coupled thereto. The transistor die comprises one or more impedance adjustment elements configured to alter an impedance at the input and/or output connections at an operating frequency of the RF transistor amplifier, where the one or more impedance adjustment elements are not connected to the input and/or output connections.

In some embodiments, the one or more impedance adjustment elements are electrically coupled to the ground connection.

In some embodiments, the plurality of transistors comprise gate, drain, and source fingers that are electrically coupled to the input, output, and ground connections, respectively, and the one or more impedance adjustment elements couple a respective source finger to the ground connection.

In some embodiments, the transistor die further comprises a gate bus that electrically couples the gate fingers, and a drain bus that electrically couples the drain fingers. The one or more impedance adjustment elements are configured to provide impedance matching and/or harmonic termination at the input and/or output connections based on at least one of: a quantity of the one or more impedance adjustment elements on the respective source finger; respective locations of the one or more impedance adjustment elements on the respective source finger, relative to the gate bus or the drain bus of the transistor die; or a unit gate width of the gate fingers.

In some embodiments, the one or more impedance adjustment elements are configured to provide a short circuit condition at the input connection and/or at the output connection of the transistor die at one or more harmonic frequencies of the operating frequency.

In some embodiments, the one or more impedance adjustment elements comprise at least one first conductive via or pillar on the respective source finger proximate the gate bus and configured to provide the harmonic termination at the input connection, and/or at least one second conductive via or pillar on the respective source finger proximate the drain bus and configured to provide the harmonic termination at the output connection.

In some embodiments, the one or more impedance adjustment elements are configured to provide the impedance matching at the input connection and/or at the output connection of the transistor die at the operating frequency.

In some embodiments, the one or more impedance adjustment elements comprise at least one conductive via or pillar on the respective source finger proximate the drain bus and configured to provide impedance matching at the input connection.

In some embodiments, the transistor die is a second transistor die, and the RF transistor amplifier is a multi-stage amplifier that further includes a first transistor die, where the input connection of the second transistor die is coupled to an output connection of the first transistor die.

In some embodiments, the one or more impedance adjustment elements comprise: one or more conductive vias that are internal to the semiconductor structure; and/or one or more conductive pillars that extend external to the semiconductor structure.

In some embodiments, the one or more conductive vias and/or the one or more conductive pillars are asymmetrically arranged on a respective source finger of the plurality of transistors.

According to some embodiments, a radio frequency (RF) transistor amplifier includes a transistor die comprising a semiconductor structure including a plurality of transistors comprising gate, drain, and source fingers that are electrically coupled to input, output, and ground connections, respectively. The transistor die comprises at least one impedance adjustment element that is electrically coupled to a respective source finger in an asymmetric arrangement, and is configured to alter an impedance at the input and/or output connections at an operating frequency of the RF transistor amplifier.

In some embodiments, the least one impedance adjustment element comprises at least one conductive via that is internal to the semiconductor structure, and/or at least one conductive pillar that extends external to the semiconductor structure.

In some embodiments, the transistor die further comprises a gate bus that electrically couples the gate fingers, and a drain bus that electrically couples the drain fingers. The least one impedance adjustment element is on the respective source finger proximate the gate bus or proximate the drain bus.

In some embodiments, the at least one impedance adjustment element is configured to provide impedance matching at the input and/or output connections of the transistor die at the operating frequency.

In some embodiments, the at least one impedance adjustment element is on the respective source finger proximate the drain bus and is configured to provide the impedance matching at the input connection.

In some embodiments, the at least one impedance adjustment element consists of a single conductive via or pillar on the respective source finger proximate the drain bus.

In some embodiments, the transistor die is a second transistor die, and the RF transistor amplifier is a multi-stage amplifier that further includes a first transistor die, where the input connection of the second transistor die is coupled to an output connection of the first transistor die.

In some embodiments, the at least one impedance adjustment element is configured to provide a short circuit condition (or harmonic termination) at the input and/or output connections of the transistor die at one or more harmonic frequencies of the operating frequency.

In some embodiments, the at least one impedance adjustment element comprises: a first conductive via or pillar on the respective source finger proximate the gate bus and configured to provide the harmonic termination at the input connection; and/or a second conductive via or pillar on the respective source finger proximate the drain bus and configured to provide the harmonic termination at the output connection.

In some embodiments, the at least one impedance adjustment element is configured to provide the impedance matching or the harmonic termination based on at least one of: a quantity of the at least one impedance adjustment element on the respective source finger; respective locations of the at least one impedance adjustment element on the respective source finger, relative to the gate bus or the drain bus; or a unit gate width of the gate fingers.

In some embodiments, the at least one impedance adjustment element is not coupled to the input and/or output connections.

According to some embodiments, a method of fabricating a radio frequency (RF) transistor amplifier includes providing a semiconductor structure including a plurality of transistors; and providing one or more impedance adjustment elements in or on the semiconductor structure. The one or more impedance adjustment elements are electrically coupled to a ground connection and are configured to provide impedance matching and/or harmonic termination at input and/or output connections at an operating frequency of the RF transistor amplifier.

In some embodiments, the plurality of transistors comprise gate, drain, and source fingers that are electrically coupled to the input, output, and ground connections, respectively, and providing the one or more impedance adjustment elements comprises forming one or more conductive vias and/or pillars on a respective source finger.

In some embodiments, the semiconductor structure further comprises a gate bus that electrically couples the gate fingers, and a drain bus that electrically couples the drain fingers, and forming the one or more conductive vias and/or pillars comprises: forming at least one first via or pillar proximate the gate bus to provide the harmonic termination at the input connection; and/or forming at least one second via or pillar proximate the drain bus to provide the harmonic termination at the output connection.

In some embodiments, the semiconductor structure further comprises a gate bus that electrically couples the gate fingers, and a drain bus that electrically couples the drain fingers, and forming the one or more conductive vias and/or pillars comprises: forming at least one via or pillar proximate the drain bus to provide the impedance matching at the input connection.

In some embodiments, the semiconductor structure provides a second transistor die, and the method further comprises providing a first transistor die, where the input connection of the second transistor die is coupled to an output connection of the first transistor die.

In some embodiments, providing the one or more impedance adjustment elements comprises at least one of: forming a predetermined quantity of the one or more conductive vias and/or pillars on the respective source finger; forming the one or more conductive vias and/or pillars at respective locations on the respective source finger relative to the gate bus or the drain bus; and forming the gate fingers to have a predetermined unit gate width.

In some embodiments, the one or more impedance adjustment elements are not connected to the input and/or output connections.

In some embodiments, the method further includes providing a package substrate comprising input, output, and ground terminals; and attaching the semiconductor structure to the package substrate such that the ground terminal of the package substrate is electrically coupled to the ground connection.

In some embodiments, attaching the semiconductor structure to the package substrate comprises mounting the semiconductor structure on a surface of the package substrate in a flip chip configuration with the input, output, and ground connections adjacent the surface of the package substrate.

In some embodiments, the package substrate is free of harmonic termination and/or inter-stage impedance matching circuit elements that are coupled to the input and/or output connections.

In some embodiments, a unit gate width of the gate fingers is based on the operating frequency.

In some embodiments, the operating frequency is below about 12 GHz, or is below about 6 GHz.

In some embodiments, the semiconductor structure comprises gallium nitride and/or silicon carbide.

Other devices, apparatus, and/or methods according to some embodiments will become apparent to one with skill in the art upon review of the following drawings and detailed description. It is intended that all such additional embodiments, in addition to any and all combinations of the above embodiments, be included within this description, be within the scope of the invention, and be protected by the accompanying claims.

### BRIEF DESCRIPTION OF THE DRAWINGS

The accompanying drawings, which are included to provide a further understanding of the invention and are incorporated in and constitute a part of this application, illustrate certain embodiment(s) of the disclosure. In the drawings:
FIG. 1A is a plan view of a multi-cell transistor die including gate, drain, and source fingers.
FIG. 1B is an enlarged plan view illustrating two gate fingers of FIG. 1A.
FIG. 2 is a schematic diagram illustrating circuit element models including input, output, and ground impedances for a transistor die.
FIG. 3A is a plan view and FIG. 3B is a cross-sectional view illustrating example transistor dies including impedance adjustment elements that provide intrinsic input and/or output harmonic termination circuitry according to some embodiments of the present disclosure.
FIG. 4A is a plan view and FIG. 4B is a cross-sectional view illustrating example transistor dies including impedance adjustment elements that provide intrinsic input and/or output harmonic termination circuitry according to some embodiments of the present disclosure.
FIG. 5A is a plan view and FIG. 5B is a cross-sectional view illustrating example transistor dies including impedance adjustment elements that provide intrinsic input and/or output harmonic termination circuitry according to some embodiments of the present disclosure.
FIG. 6A is a plan view and FIG. 6B is a cross-sectional view illustrating example transistor dies including impedance adjustment elements that provide intrinsic input and/or output harmonic termination circuitry according to some embodiments of the present disclosure.
FIG. 7A is a plan view and FIG. 7B is a cross-sectional view illustrating example transistor dies including impedance adjustment elements that provide intrinsic input and/or output harmonic termination circuitry according to some embodiments of the present disclosure.
FIGS. 8A and 8B are side views of example transistor amplifier packages including transistor dies having impedance adjustment elements that provide intrinsic input and/or output harmonic termination circuitry according to some embodiments of the present disclosure.
FIGS. 8C and 8D are side views of example transistor amplifier packages including transistor dies having external impedance adjustment elements that provide input and/or output harmonic termination circuitry according to some embodiments of the present disclosure.
FIGS. 9A, 9B, 9C, 9D, 9E, and 9F are graphs illustrating effects of the impedance adjustment elements of the transistor die of FIGS. 3A and 3B.
FIGS. 10A, 10B, 10C, 10D, 10E, and 10F are graphs illustrating effects of the impedance adjustment elements of the transistor die of FIGS. 4A and 4B in comparison to the impedance adjustment elements of the transistor die of FIGS. 3A and 3B.
FIGS. 11A, 11B, 11C, 11D, 11E, and 11F are graphs illustrating effects of the impedance adjustment elements of the transistor die of FIGS. 6A and 6B.
FIGS. 12A and 12B are side views of example transistor amplifier packages including transistor dies having internal impedance adjustment elements that provide inter-stage impedance matching circuitry according to some embodiments of the present disclosure.
FIGS. 12C and 12D are side views of example transistor amplifier packages including transistor dies having external impedance adjustment elements that provide inter-stage impedance matching circuitry according to some embodiments of the present disclosure.
FIGS. 13A, 13B, 13C, 13D, and 13E are graphs illustrating effects of the impedance adjustment elements of the transistor die of FIGS. 4A and 4B in comparison with providing three conductive vias symmetrically arranged along each source finger.

### DETAILED DESCRIPTION OF EMBODIMENTS

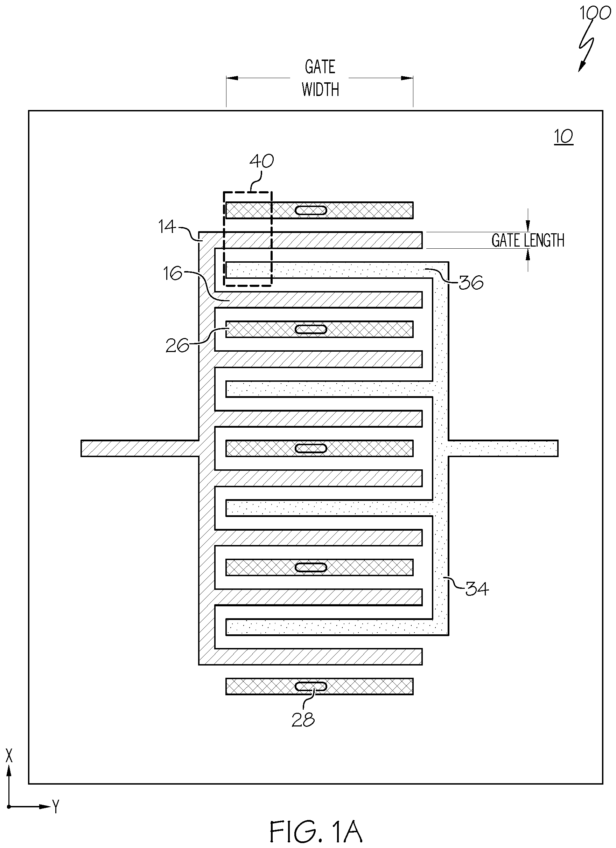

Some power amplifier configurations described herein may be implemented using a plurality of "unit cell" transistors that are fabricated on a common semiconductor die, with a plurality of the unit cells defining each transistor amplifier device. Each unit cell transistor may include a source region, a drain region and a channel region in a semiconductor material, with the channel region being between the source and drain regions. A gate electrode (or "gate"), which may be implemented as one or more elongated gate fingers 16, is provided above the channel region and extends in parallel between elongated source fingers 26 and drain fingers 36, as is schematically illustrated in FIG. 1A. Embodiments of the present disclosure are not limited to any particular transistor type, and may include, for example, high electron mobility transistor (HEMT) embodiments or metal-oxide-semiconductor field effect transistor (MOSFET) embodiments, such as laterally diffused MOSFETs (LDMOS) embodiments.

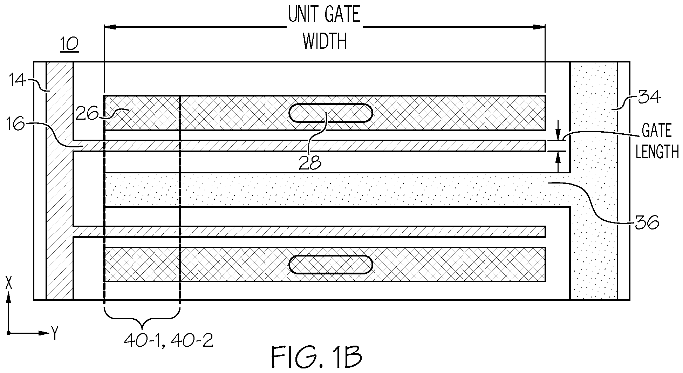

As shown in FIG. 1A, a unit cell transistor of a power amplifier semiconductor device (shown as transistor die 100) is illustrated at box 40, and includes an electrically conductive gate finger 16 that extends between adjacent source 26 and drain 36 fingers on a semiconductor structure 10, such as a Group III nitride (e.g., GaN) and/or silicon carbide (SiC) semiconductor structure. The gate fingers 16 of respective unit cells 40 are spaced apart from each other along a first direction (e.g., the X-direction in FIG. 1A) and extend (e.g., in parallel) in a second direction (e.g., the Y-direction in FIG. 1A). FIG. 1B is an enlarged view of two gate fingers 16 of FIG. 1A that provide pairs of adjacent unit cell transistors 40-1, 40-2.

The gate fingers 16 are electrically connected to each other through a gate bus 14, which may be coupled to or may include at least one gate pad or gate contact (also referred to herein in some examples as an input connection) for external connection. Electrically conductive source fingers 26 are spaced apart from each other along the first direction and extend in the second direction. The source fingers 26 may be electrically connected to each other by through vias 28 that extend through the semiconductor structure 10 (also referred to herein as through semiconductor vias or TSVs 28). The TSVs 28 may be coupled to or may include at least one source pad or source contact (also referred to herein in some examples as a ground connection). In some embodiments, the source fingers 26 may be electrically connected to the source pad or contact(s) (not visible in FIG. 1A) on the bottom side of the semiconductor structure 10. Electrically conductive drain fingers 36 are likewise spaced apart from each other along the first direction and extend in the second direction, and are electrically connected to each other through a drain bus 34, which may be coupled to or may include at least one drain pad or drain contact (also referred to herein in some examples as an output connection) for external connection. Since the gate fingers 16 are electrically connected, the drain fingers 36 are electrically connected, and the source fingers 26 are electrically connected, it can be seen that the unit cell transistors 40 are electrically connected together in parallel.

The gate 16, source 26, and drain 36 fingers may each comprise a respective conductive material, such as a metal or a metal alloy. Each gate finger 16 extends along the Y-direction between a pair of adjacent source 26 and drain 36 fingers. The "gate length" refers to the distance of the gate metallization 16 in the X-direction (between source 26 and drain 36 fingers). Some embodiments of the present disclosure may include a gate length of about 400 nanometers (nm) to about 150 nm or less, for example, about 100 nm or about 60 nm or less. The power handling capability of the semiconductor device 10 may be proportional to its "gate periphery." The gate periphery of semiconductor device 10 may refer the sum of the gate lengths for each gate finger 16.

The "gate width" is the distance by which the gate fingers 16 and the source 26 and drain 36 fingers overlap along the Y-direction. That is, "width" of a gate finger 16 refers to the dimension of the gate finger 16 that extends in parallel to the adjacent source/drain fingers 26/36 (the distance along the Y-direction). As shown in FIG. 1B, the "unit gate width" (UGW) may refer to the width of one gate finger 16. Some embodiments of the present disclosure may include gate fingers 16 having a UGW of about 500 micrometers (µm; also referred to as microns) or less. The total or overall gate width may refer to the sum of the gate widths of all of the gate fingers 16 of the semiconductor device 10. As such, devices with the same total gate width (e.g., 1000 microns) may be implemented using a smaller number of wider gate fingers 16 (e.g., two gate fingers 16 in parallel, each having a UGW of 500 microns, as shown in the example of FIG. 1B), or a greater number of narrower gate fingers 16 (e.g., ten gate fingers 16 in parallel, each having a UGW of 100 microns, which would provide a lower resistance). The total gate width of devices described herein may be denoted by the number of gate fingers times the UGW (e.g., a 10 x 100 µm device in the preceding example, or a 2 x 500 µm device in the example described with reference to FIG. 1B).

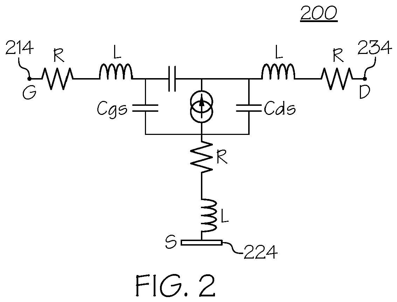

FIG. 2 is a schematic diagram illustrating circuit element models including input, output, and ground impedances for an RF transistor die, also referred to herein as a distributed modelling approach. In FIG. 2, the input impedance as seen at the gate G, the output impedance as seen at the drain D, and the ground impedance as seen at the source S are shown as respective series resistance-inductance (RL) circuits. Capacitor circuit elements represent the gate-to-source capacitance Cgs and drain-to-source capacitance Cds, with the understanding that no physical components provide connections between the gate G and source S, or between the drain D and source S, respectively.

Designing and manufacturing RF transistor amplifier devices to meet desired performance targets may be challenging due to effects (at fundamental and/or harmonic frequencies) caused by such impedances at the input, output, and/or ground connections of a transistor die, particularly at higher frequencies.

For example, in some conventional configurations, the grounding of a power amplifier (e.g., at the source terminal of a transistor die) is implemented by through semiconductor vias that connect an electrical ground (e.g., a ground plane of a printed circuit board) to the source or other ground terminal of the power amplifier. As shown in FIGS. 1A and 1B, some devices may implement grounding of the source by one conductive via 28 that is centrally located on a respective source finger 26. Alternatively, two conductive vias may be symmetrically provided on opposite ends of a respective source finger 26, or three conducive vias may be symmetrically arranged along a respective source finger 26. The associated source inductance is thus a fixed value that is internal to the transistor die, which may typically be minimized (e.g., by reducing the thickness of the semiconductor structure and thus "length" of the through semiconductor via) for high frequency performance. Such on-finger via arrangements may present challenges for devices configured for higher frequency operation, as one or more dimensions of the source 26, drain 36, and gate 16 fingers (e.g., the unit gate width UGW) may approach the dimensions of the conductive vias 28.

Also, some conventional devices may couple a series resonator (e.g., a series L-C circuit) to the input connection of a transistor die to provide termination of harmonic products, that is, to provide resonance at a specific operating frequency such that the impedance at the operating frequency is substantially zero and current is thus shorted to ground. However, doing so may increase input capacitance, which can degrade operating stability (which may be quantified by a stability factor K). Such resonator elements may also be bandwidth-limited.

Some embodiments of the present disclosure may arise from recognition that some attachment configurations and/or operating frequencies may allow for indirect tuning of the input impedance (e.g., as seen at the gate contact) and/or output impedance (e.g., as seen at the drain contact) by varying the ground impedance of the transistor die (e.g., as seen at the source contact). For example, some RF amplifier packages may include transistor dies that are configured for attachment in a "flip-chip configuration" with input (e.g., gate), output (e.g., drain) and ground (e.g., source) contacts or connections on a surface of the respective dies that are not directly mounted on a conductive flange of a package, that is, where the ground connection is implemented without a direct connection to a conductive submount. Also, at lower operating frequencies (e.g., below about 6 GHz, but greater in some embodiments depending on gate width), the UGW may be significantly greater than the via dimensions (as UGW may typically increase as operating frequencies decrease).

Such applications may present the opportunity to implement source grounding by a combination of external conductive elements (such as copper pillars, solder bumps, and/or external vias in a mounting substrate (e.g., PCB)) and internal conductive elements (such as through semiconductor vias that are internal to the transistor die). As used herein in the context of a transistor die, "external" elements may be provided on exterior surfaces of or otherwise extending outside the semiconductor structure of the transistor die, while "internal" elements may be implemented within the semiconductor structure of the transistor die, for example, on or between interior layers of or otherwise within the semiconductor structure of the transistor die.

European Patent Application No. 22306636.6, filed October 28, 2022 (the disclosure of which is incorporated by reference herein in its entirety) describes the use of one or more external conductive elements to provide an improved stability factor K. In particular, European Patent Application No. 22306636.6 describes providing one or more external inductance adjustment elements between the source contacts of the transistor die and a package ground terminal, in order to achieve a stability factor K of greater than or equal to 1 for an operating frequency range of the transistor die.

Embodiments of the present disclosure provide transistor die configurations (and associated fabrication methods) that implement one or more internal conductive elements and/or externally extending conductive elements (also referred to herein as internal or external impedance adjustment elements, and collectively as on-die impedance adjustment elements) to control input and/or output impedances for the transistor die, for example, to provide harmonic termination at one or more harmonic frequencies of a desired operating frequency or range at the input and/or output connections, and/or to provide impedance matching (e.g., inter-stage impedance matching) at the desired operating frequency or range. As used herein, harmonic termination circuitry refers to networks or circuit elements that are arranged or otherwise configured to provide resonances as specific frequencies or otherwise reduce effects of harmonic products. The internal impedance adjustment elements may include conductive vias (e.g., through semiconductor vias (TSVs), such as through silicon carbide (TSiC) vias) and/or other conductive elements or other internal metallization that extend in or between layers of the semiconductor structure. The external impedance adjustment elements may include conductive pillars (e.g., copper pillars) that are on or extend through one or more external surfaces of the semiconductor structure. In some embodiments, the internal and/or external impedance adjustment elements may not be physically connected to the input (e.g., gate) or output (e.g., drain) contacts of the transistor die, but (without being bound by theory) may nevertheless define at least a portion of the gate return path and/or the drain return path based on connection to the ground (e.g., source) contact of the transistor die.

Embodiments of the present disclosure thus provide one or more on-die impedance adjustment elements that are internal or external to the semiconductor structure of a transistor die, are electrically coupled between the transistors and the ground connection (or are otherwise not connected to the input and/or output connections), and are configured to provide impedance matching and/or harmonic termination at the input and/or output connections at an operating frequency of the RF transistor amplifier. In some embodiments, the internal and/or external impedance adjustment elements may be sized and/or arranged (e.g., asymmetrically along the length of respective source fingers or otherwise relative to the gate/input or drain/output terminals of the die) to provide controlled grounding of the source of the transistor die, so as to improve or optimize the intrinsic impedances at the gate and/or drain of the transistor at a desired operating frequency and/or harmonic frequencies thereof. In particular, embodiments of the present disclosure provide application- and frequency-specific implementation of the number and location(s) of conductive vias (e.g., on a source finger relative to the gate and/or drain contacts) and/or the unit gate width (UGW), to control input and output impedances and thereby implement impedance matching and/or harmonic termination circuitry internal to the transistor die.

In some embodiments, the impedance adjustment elements may be configured to improve harmonic termination associated with high efficiency power amplifiers by achieving a series resonance or short circuit condition at one or more harmonic frequencies (i.e., such that impedance is minimized at one or more harmonic frequencies and current is effectively shorted to ground). The impedance adjustment elements internal to the transistor die may thereby reduce the need for harmonic termination circuit elements that are external to the die. In some embodiments, the short circuit condition at one or more harmonic frequencies may be achieved primarily or even entirely by the impedance adjustment elements that are internal to the transistor die, that is, free of input and/or output harmonic termination circuit elements that are external to the transistor die, depending on the operating frequency band and application (e.g., in some monolithic microwave integrated circuit (MMIC)-type applications). Embodiments described herein may thereby provide more compact and broader solutions from an RF frequency bandwidth standpoint, that is, to obtain more compact power amplifiers (e.g., with reduced semiconductor surface area and/or fewer components) and broader operating bandwidth.

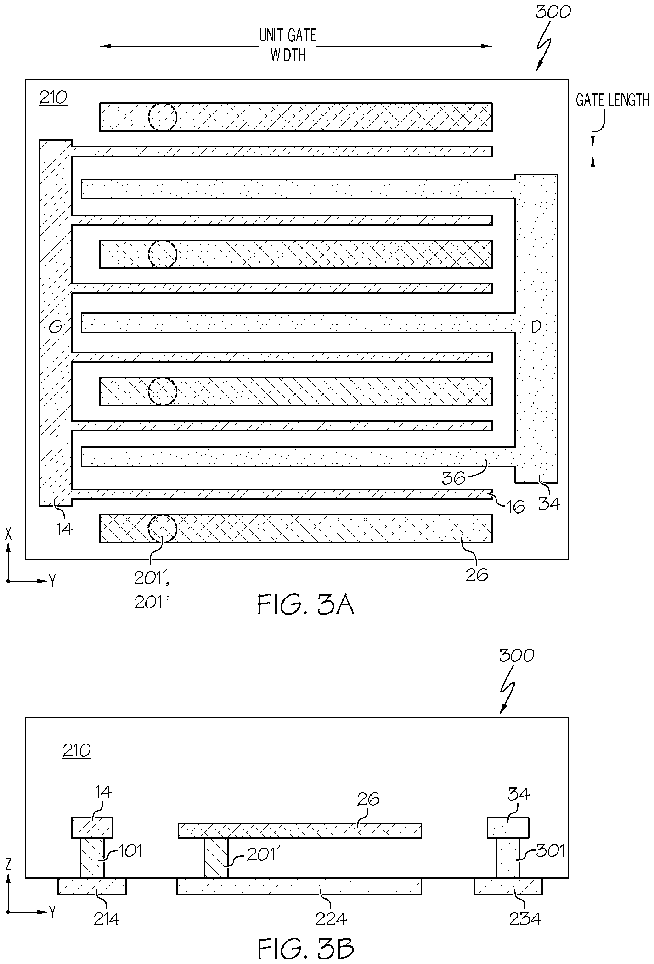

FIGS. 3A-3B, 4A-4B, 5A-5B, 6A-6B, and 7A-7B illustrate example transistor dies 300, 400, 500, 600, and 700 including impedance adjustment elements 201 that provide intrinsic input and/or output harmonic termination circuitry and/or impedance matching circuitry according to some embodiments of the present disclosure. As shown in FIGS. 3A to 7B, each of the transistor dies 300, 400, 500, 600, 700 include a semiconductor structure 210 having a plurality of transistors and input 214, output 234, and ground 224 connections (e.g., as provided by gate, drain, and source contacts, respectively) electrically coupled thereto. The transistor dies 300, 400, 500, 600, 700 may be formed (e.g., by epitaxial growth and other semiconductor processing and metallization steps) or otherwise provided on the semiconductor structure 210. For example, the semiconductor structure 210 may include Group III-nitride based materials (such as gallium nitride (GaN)) and/or silicon carbide (SiC). Other materials for the semiconductor structure 210 may include, but are not limited to sapphire, diamond, aluminum nitride, aluminum gallium nitride, gallium nitride, silicon, GaAs, LGO, ZnO, LAO, InP, and the like. The semiconductor structure 210 may be configured to provide various transistor types, such HEMTs or MOSFETs (including LDMOS).

The transistors of each of the transistor dies 300, 400, 500, 600, 700 include gate 16, drain 36, and source 26 fingers that are electrically coupled to the input 214, output 234, and ground 224 connections, respectively. The transistor dies 300, 400, 500, 600, 700 further include a gate bus 14 that electrically couples a plurality of gate fingers 16, and a drain bus 34 that electrically couples a plurality of drain fingers 36. The gate bus 14 may be electrically connected to a gate contact G (which provides the input connection 214 in this example) by one or more conductive vias 101, and the drain bus 34 may be electrically coupled to the drain contact D (which provides the output connection 234 in this example) by one or more conductive vias 301. Respective source fingers 26 may be electrically coupled to a source contact S (which provides the ground connection 224 in this example) by one or more conductive vias 201'. As described in further detail herein, the conductive via(s) 201' may implement impedance adjustment elements 201 that are internal to the semiconductor structure 210 and are electrically coupled to the ground connection 224. Additionally or alternatively, one or more conductive pillar structures 201" may be provided in place of or in combination with the conductive via(s) 201' to implement impedance adjustment elements 201 that extend external to the semiconductor structure 210. In FIGS. 3A to 7B, the semiconductor structure 210 is simplified to illustrate the respective components (i.e., the gate fingers 16, the source fingers 26, and the drain fingers 36) and the conductive vias 101, 201', 301 that electrically connect the conductive fingers 16, 26, 36 to the gate G, source S, and drain D contacts that provide the input 214, ground 224, and output 234 connections, respectively, for the transistor dies 300, 400, 500, 600, and 700.

The transistor dies 300, 400, 500, 600, 700 can be configured for operation in a desired frequency range based on a unit gate width (UGW) of a respective gate finger 16. In particular, the unit gate width UGW and/or number of gate fingers (NGF) may be scaled based on (i.e., to "match") a desired operating frequency range. For example, some embodiments may of the present disclosure include gate fingers 16 having a UGW of about 500 µm or less, e.g., about 300 to about 400 microns, about 200 to 300 microns, or about 100 to 200 microns, depending on the operating frequency range. In some embodiments, the UGW may be configured for an operating frequency range of about 500 MHz to about 12 GHz, or about 2 GHz to about 6 GHz. Accordingly, the UGW for a respective gate finger 16 can be configured based on the desired operating frequency range, where, in general, the lower the operating frequency range, the larger the UGW. As noted above, a same total gate width may be implemented using a greater number of narrower gate fingers 16 (e.g., ten narrower gate fingers 16 in parallel), or a comparatively fewer number of "wider" gate fingers 16 (shown as "longer" in the Y-direction). A greater number of narrower gate fingers 16 (i.e., "shorter" in the Y-direction) may provide a lower resistance, while a comparatively fewer number of wider gate fingers 16 (e.g., two wider gate fingers 16 in parallel) may provide improved stability and/or greater freedom for conductive via placement. More generally, the UGW (and the number of fingers for a given power level) may be selected for a given operating frequency range.

Still referring to FIGS. 3A to 7B, one or more impedance adjustment elements 201 (e.g., conductive vias 201' and/or conductive pillars 201") are provided internal to the semiconductor structure 210. The impedance adjustment element(s) 201 provide internal tuning elements or "knobs" that can be configured to adjust or otherwise control the input and/or output impedance seen at the input and/or output connections 214/234 of the transistor dies 300, 400, 500, 600, and 700. As described herein, the impedance adjustment element(s) 201 may thereby be configured to provide harmonic termination at the RF operating frequency or frequency range of a RF transistor amplifier, so as to achieve desired RF performance (e.g., efficiency). The impedance adjustment elements 201 may be electrically coupled to the ground connection 224 (in particular, to the source fingers 26 of the transistors), but may not be directly or physically connected to the input and/or output connections 214/234. In the examples shown herein, the impedance adjustment elements 201 are primarily illustrated with reference to one or more conductive vias 201' (or conductive pillars 201") on a respective source finger, but it will be understood that embodiments of the present disclosure are not so limited.

For example, as shown in FIGS. 3A to 4B, the impedance adjustment elements 201 may be configured to provide the harmonic termination at the input and/or output connections 214/234 based on the configuration of the conductive vias 201'/pillars 201" and/or the UGW. In particular, a number or quantity of the conductive via(s) 201' and/or pillars 201" and the respective locations and/or spacings of the conductive vias 201' and/or pillars 201" (relative to the gate input or the drain output) on a respective source finger may be used to control the input and/or output impedance at the fundamental operating frequency (i.e., f0, for impedance matching) and/or at one or more harmonic frequencies (e.g., 2f0, 3f0, for harmonic termination). For example, FIGS. 3A and 3B illustrate that the input resonance may be adjusted based on the distance between the gate bus 14 and the nearest conductive via 201' (and/or pillar 201") on a respective source finger 26, also referred to herein as a gate-side via (or pillar). In particular, in some embodiments, providing a conductive via or pillar on a respective source finger in close proximity (e.g., fully or partially justified toward, or in some embodiments as close as possible based on the fabrication method or processing rules) to the gate bus 14 may achieve an input impedance that provides a short circuit condition at the second harmonic frequency 2f0 of the operating frequency of the RF transistor amplifier.

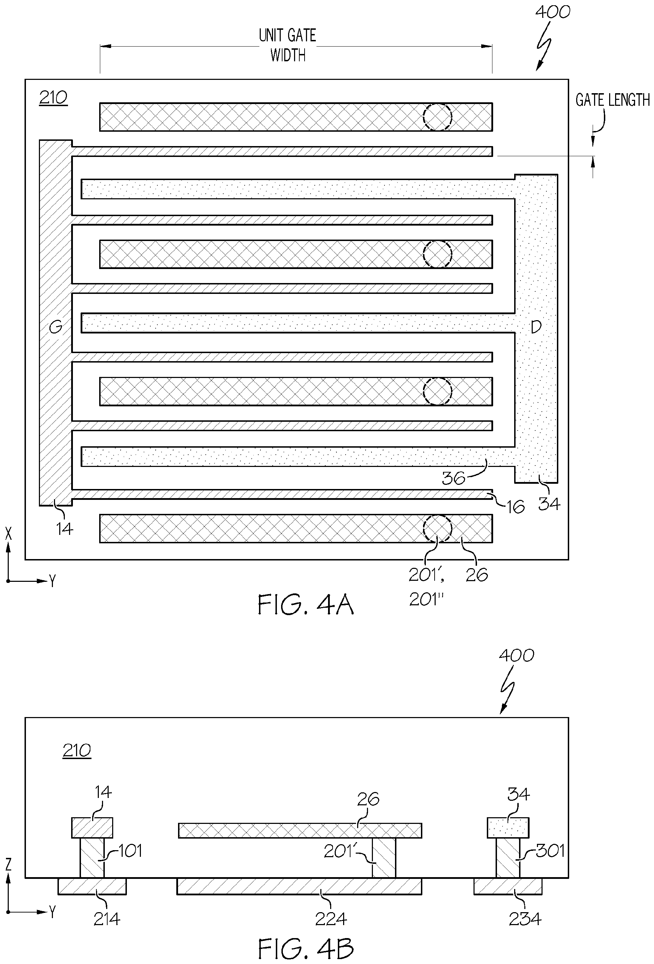

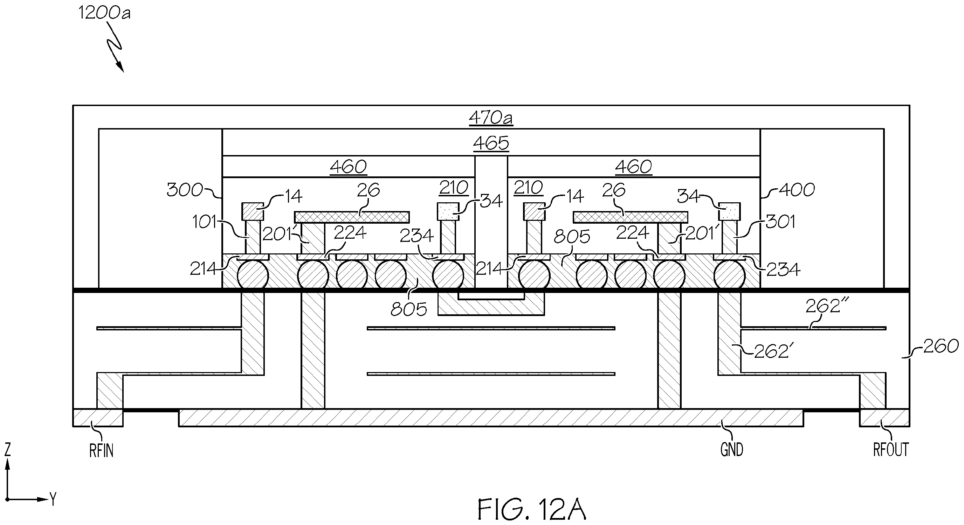

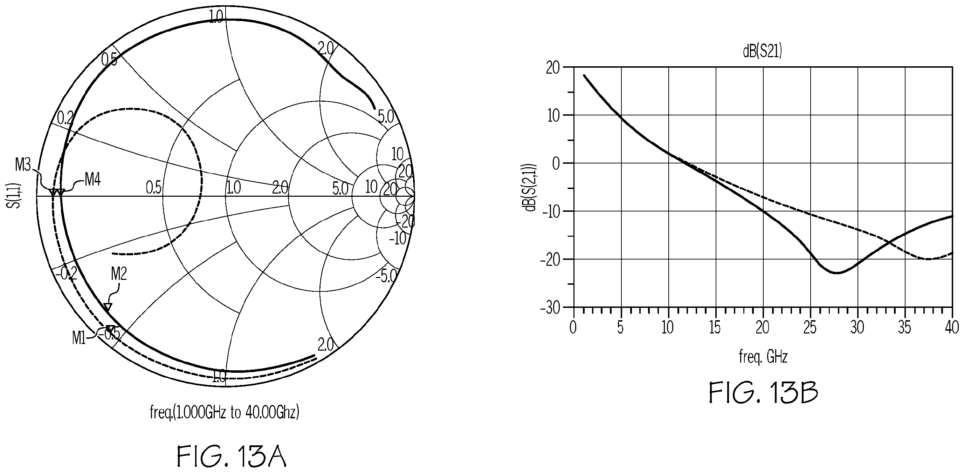

FIGS. 4A and 4B illustrate that the output resonance at one or more harmonic frequencies may be similarly adjusted based on the distance between the drain bus 34 and the nearest conductive via 201' (or pillar 201") on a respective source finger 26, also referred to herein as a drain-side via (or pillar). In some embodiments, only a single conductive via 201' or pillar 201" (e.g., one gate-side via/pillar or one drain-side via/pillar) may be asymmetrically arranged on each source finger 26, such that each source finger 26 is free of additional vias or pillars thereon. The drain-side via 201' (and/or pillar 201") configuration shown in FIGS. 4A and 4B may also be used to improve the input impedance at the fundamental frequency, for example, to provide input impedance matching (e.g., from the output of a driver transistor die) where the die 400 provides an output stage of a multi-stage amplifier, as discussed below with reference to FIGS. 12A-12D and 13A-13E.

The positionings of the conductive vias 201' may be achieved by masking and/or etching operations to form via holes in the semiconductor structure 210 at the desired locations along the source fingers 26, and depositing a conductive material in the via holes to form the conductive vias. While a smaller UGW (and thus, a smaller source finger between adjacent gate fingers 16) may be required for higher operating frequencies, the UGW may (depending on the desired operating frequency) nevertheless allow for source fingers 26 with sufficient dimensions relative to the dimensions of the conductive vias 201' to provide the desired positioning of the conductive vias 201' along the length (e.g., along the Y-direction) of a respective source finger.

Additionally, the UGW itself may be used to control the input and/or output impedance. For example, in FIGS. 3A and 3B, the input resonance may be adjusted based on the positioning of the conductive via on the source finger proximate the gate bus 14, while the output resonance may be adjusted based on selection of the UGW, which as noted above refers to the distance by which the gate fingers 16 and the source 26 and drain 36 fingers overlap along the Y-direction. In particular, in some embodiments, the UGW may be selected to achieve an output impedance that provides a short circuit condition at the second harmonic frequency 2f0 or at a third harmonic frequency 3f0 of the operating frequency of the RF transistor amplifier. In some embodiments, the operating frequency may be below about 12GHz, or below about 6 GHz, e.g., about 2 GHz to about 6 GHz. That is, the width of the gate fingers 16 may provide an additional impedance adjustment element in some embodiments.

FIGS. 3A to 4B thereby illustrate that the UGW and/or the position/number of conductive vias 201' and/or pillars 201" on the source fingers 26 (e.g., relative to the gate bus 14 or drain bus 34) may provide tuning elements for adjusting the series resonance at the input and/or output connections 214/234. Accordingly, based on the desired operating frequency range of a transistor amplifier package, one or more transistor dies 300, 400 may be provided with respective gate fingers 16 having a UGW and/or impedance adjustment elements 201 on respective source fingers 26 so as to provide desired or predetermined input and/or output impedance values that achieve a short circuit condition at the input and/or output connections 214/234. In some embodiments, the position/number of conductive vias 201' and/or pillars 201" on the source fingers 26 and/or the UGW may allow for sufficient impedance adjustment so as to attain series resonance at both the input connection 214 (e.g., for the second harmonic 2f0) and at the output connection 234 (e.g., for the second harmonic 2f0 or the third harmonic 3f0), for example, at operating frequencies of about 6 GHz or less.

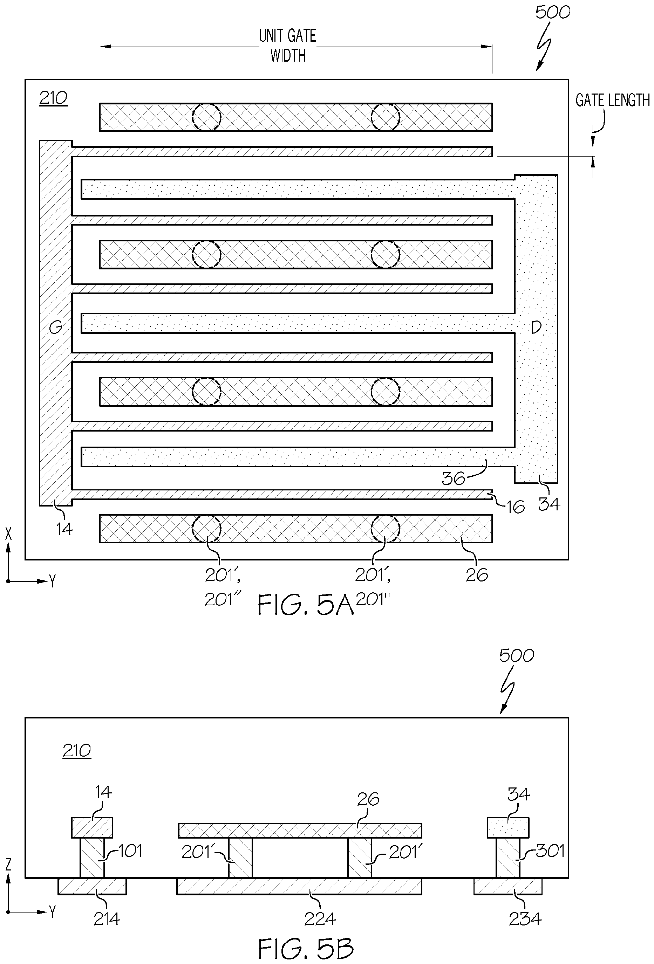

FIGS. 5A and 5B illustrate another example transistor die 500 including impedance adjustment elements 201 that provide intrinsic input and output harmonic termination circuitry. In particular, FIGS. 5A and 5B illustrate that the relative positions or locations of multiple conductive vias 201' and/or pillars 201" on a respective source finger 26 (with respect to the gate/input side and the drain/output side of the device) may also provide internal tuning elements or knobs that can be adjusted or selected to provide a desired RF performance (e.g., efficiency) improvement.

In the example of FIGS. 5A and 5B, the transistor die 500 includes at least one first conductive via that is positioned proximate the gate contact (or the gate bus 14 coupled thereto) to provide a harmonic termination circuit at the input connection 214, and at least one second conductive via that is positioned proximate the drain contact (or the drain bus 34 coupled thereto) to provide a harmonic termination circuit at the output connection 234. Input resonance may be adjusted based on the distance between the gate bus 14 or gate contact and the nearest conductive via on a respective source finger, while output resonance may be adjusted based on the distance between the drain bus 34 or drain contact and the nearest via on a respective source finger.

In some embodiments, positioning the first conductive via(s) 201 'and/or pillar(s) 201" on a respective source finger in close proximity to the gate bus 14 may achieve an input impedance that provides a short circuit condition at the second harmonic frequency 2f0 of the operating frequency of a RF transistor amplifier. Likewise, positioning the second conductive via(s) 201' and/or pillar(s) 201" on a respective source finger in close proximity to the drain bus 34 may achieve an output impedance that provides a short circuit condition at the second harmonic frequency 2f0 or at a third harmonic frequency 3f0 of the operating frequency of the RF transistor amplifier. In other words, in FIGS. 5A and 5B, the impedance adjustment elements 201 are configured to provide internal tuning knobs where knob 1 is the location of the gate-side conductive via(s) 201' and/or pillar(s) 201" on a respective source finger, while knob 2 is the location of the drain-side conductive via(s) 201' and/or pillar(s) 201" on a respective source finger (which may be the same source finger including the gate-side conductive via(s) 201' and/or pillar(s) 201", or a different source finger). In some embodiments, as similarly discussed above with reference to FIGS. 3A to 4B, the gate fingers 16 may provide an additional impedance adjustment element, where knob 3 is the UGW of the gate fingers 16.

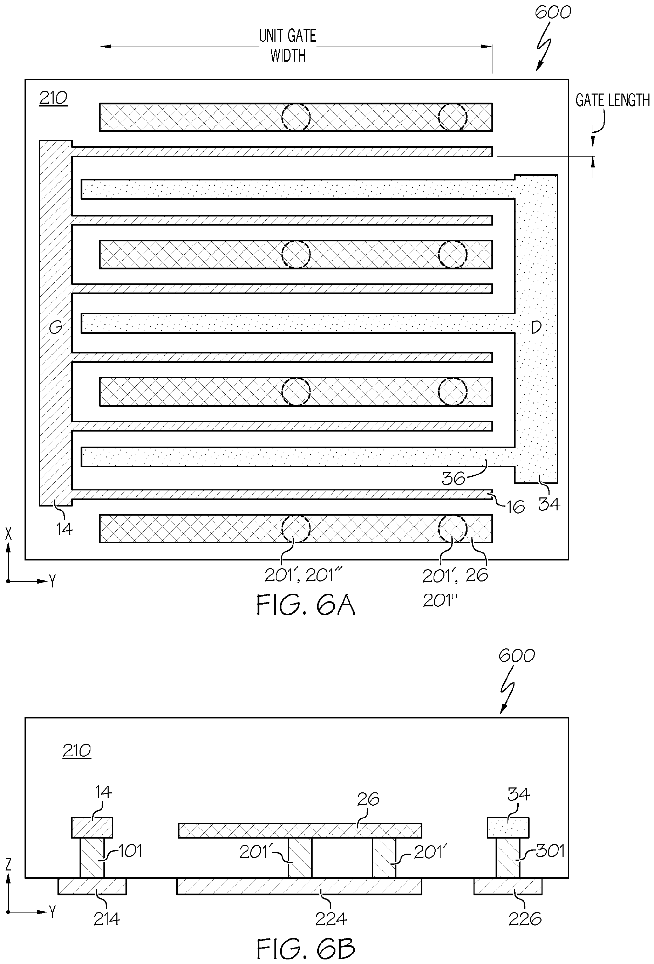

FIGS. 6A and 6B illustrate another example transistor die 600 including impedance adjustment elements 201 that provide intrinsic input and output harmonic termination circuitry. In particular, FIGS. 6A and 6B illustrate a configuration of the impedance adjustment elements 201 to provide internal tuning knobs where knob 1 is adjusted by positioning one or more conductive via(s) 201' and/or pillar(s) 201" at a centralized location on a respective source finger, while knob 2 is adjusted by positioning one or more drain-side conductive via(s) 201' and/or pillar(s) 201" on the same (or different) source finger.

As discussed above, input resonance may be adjusted based on the distance between the input connection 214 and the nearest conductive via 201' and/or pillar 201" on a respective source finger 26, while output resonance may be adjusted based on the distance between the output connection 234 and the nearest via 201' and/or pillar 201" on a source finger 26. However, as output capacitance Cds may be significantly less than input capacitance Cgs in the transistor die 600, in some embodiments it may be advantageous from a performance or efficiency perspective to achieve a short circuit condition at the second harmonic frequency 2f0 of the operating frequency of an RF transistor amplifier at the input connection 214, but at a third harmonic frequency 3f0 at the output connection 234.

To address the ratio or asymmetry between input capacitance Cgs and output capacitance Cds, the example of FIGS. 6A and 6B provides at least one first conductive via 201' and/or pillar 201" that is positioned proximate a central location on a respective source finger, and at least one second conductive via and/or pillar 201" that is positioned on the respective source finger proximate the drain contact (or the drain bus 34 coupled thereto). The impedance adjustment elements 201 may thereby be configured to achieve a short circuit condition at the second harmonic frequency 2f0 at the input connection 214, and at the third 3f0 (or other higher) harmonic frequency at the output connection 234. In some embodiments, as similarly discussed above with reference to FIGS. 3A to 4B, the gate fingers 16 may provide an additional internal impedance adjustment element or tuning knob, where knob 3 is adjusted by the UGW of the gate fingers 16.

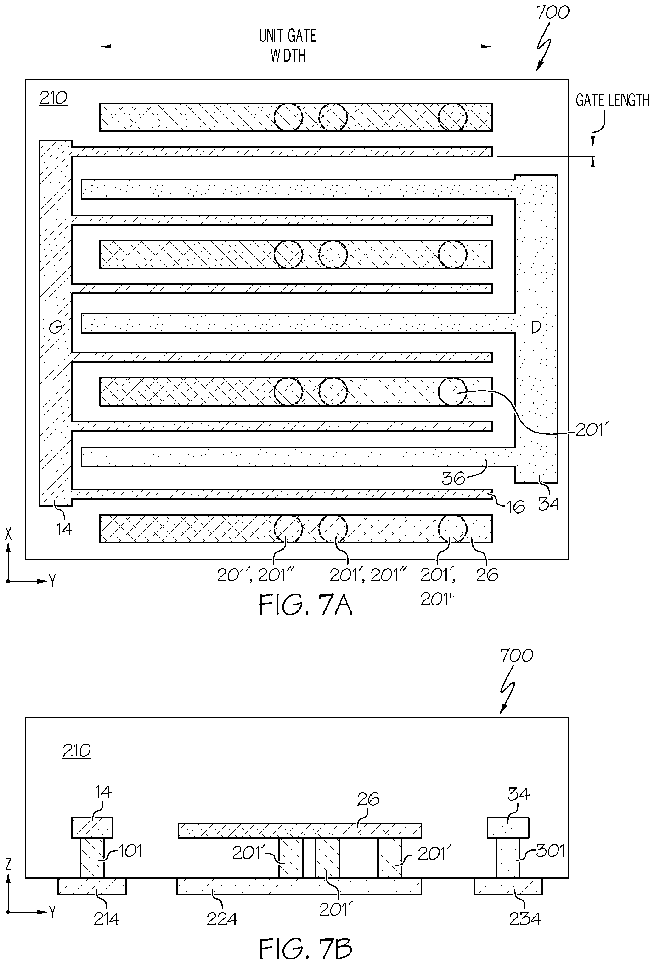

FIG. 7A is a plan view and FIG. 7B illustrate another example transistor die 700 including impedance adjustment elements 201 that provide intrinsic input and output harmonic termination circuitry. In particular, FIGS. 7A and 7B illustrate a configuration of the impedance adjustment elements 201 to address the ratio or asymmetry between input capacitance Cgs and output capacitance Cds, by including two or more first conductive vias 201' and/or pillars 201" positioned proximate a central location on a respective source finger, and at least one second conductive via 201' that is positioned proximate the drain contact on some or all of the source fingers 26, that is, in an asymmetric configuration. More generally, the example of FIGS. 7A and 7B illustrate that the number of vias 201' and/or pillars 201" (e.g., one, two, three, four, etc.) per source finger may be selected to provide the desired input and/or output harmonic termination, and need not be symmetrically configured on each source finger. Also, the number of vias positioned at a given location on a source finger may be increased in some embodiments in order to increase current handling capability. Moreover, while primarily illustrated with reference to similarly-sized vias and/or pillars, the dimensions (e.g., diameter) of each via 201' and/or pillar 201" may differ or may otherwise be configured to provide a desired inductance. That is, impedance adjustment elements 201 as described herein may be implemented by varying the configuration (e.g., size, number, and/or placement) of the vias 201'/pillars 201", where the via/pillar configuration may differ on a given source finger 26, and/or may differ from one source finger 26 to another.

Accordingly, in the examples of FIGS. 3A-3B, 4A-4B, 5A-5B, 6A-6B, and 7A-7B, one or more impedance adjustment elements 201 are configured to provide a series resonance or short circuit condition at the input connection 214 and/or at the output connection 234 of the transistor die at one or more harmonic frequencies of the operating frequency. The impedance adjustment elements 201 may be conductive vias 201' or other internal conductive elements that are internally coupled to the ground connection 224 of the transistor die 300, 400, 500, 600, 700 (e.g., between the transistors and the ground contact 224), but are not connected to the input and/or output connections 214/234. Additionally or alternatively, the impedance adjustment elements 201 may be conductive pillars 201" or other externally extending conductive elements that are coupled to the ground connection 224 of the transistor die 300, 400, 500, 600, 700 (e.g., between the transistors and the ground contact 224), but are not connected to the input and/or output connections 214/234. More generally, the conductive vias 201', UGW, and/or other internal impedance adjustment elements 201, as well as the conductive pillars 201" and/or other external impedance adjustment elements 201 may be implemented alone or in any combination to provide input and/or output impedance control, for impedance matching and/or harmonic termination as described herein. In some embodiments, the one or more impedance adjustment elements 201 may be configured to provide the short circuit condition free of contributions from harmonic termination circuit elements that are external to the semiconductor structure 210 of the transistor die 300, 400, 500, 600, 700.

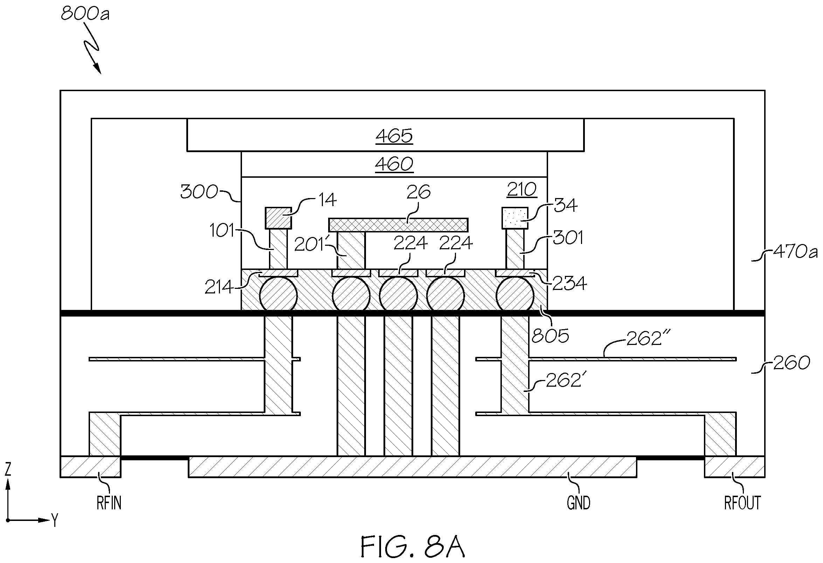

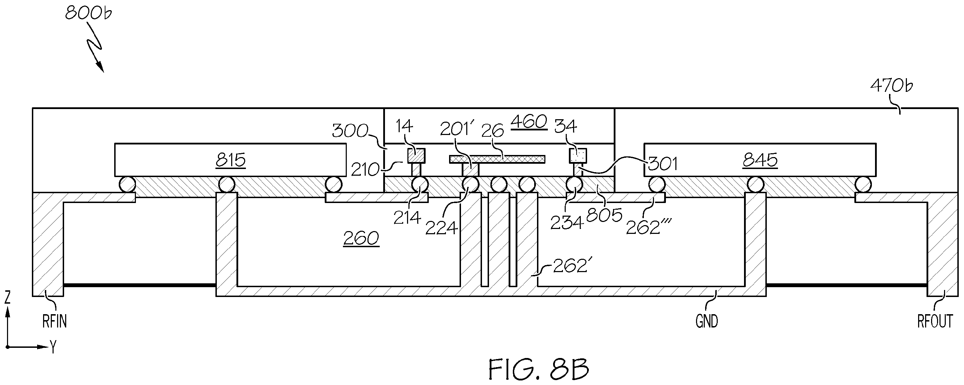

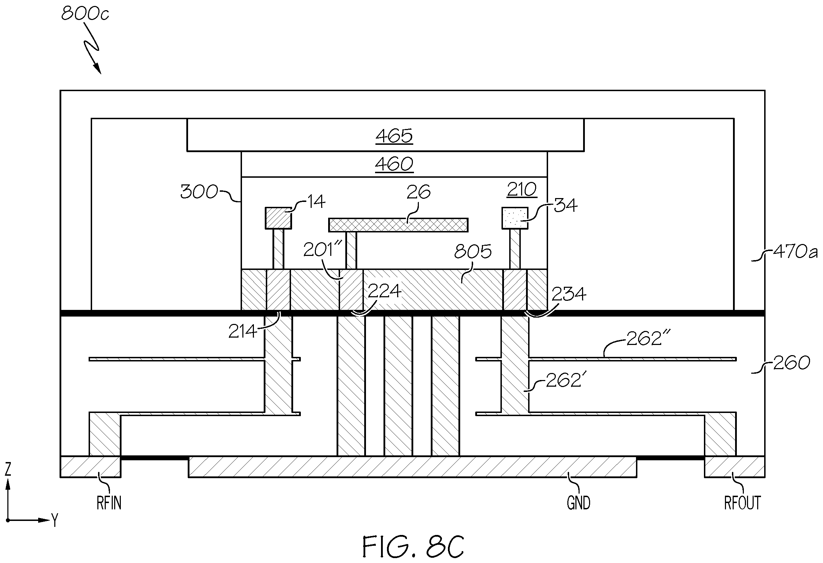

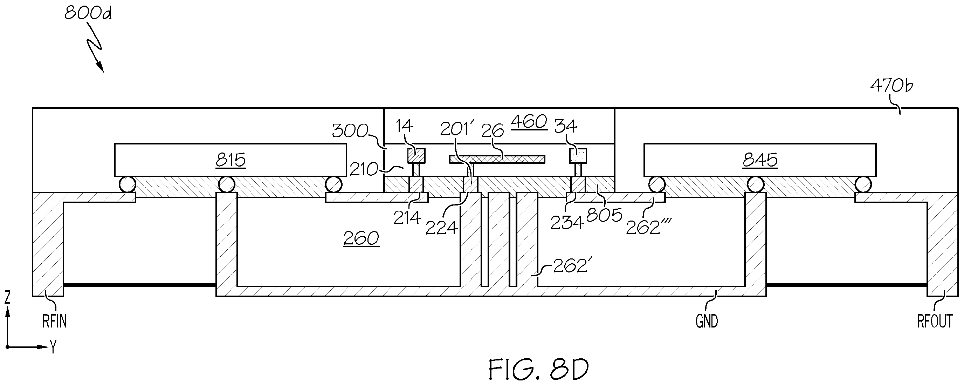

FIGS. 8A and 8B are side views of example transistor amplifier packages including transistor dies with impedance adjustment elements 201 implemented by one or more conductive vias 201' that are internal to the semiconductor structure 210 to provide intrinsic input and/or output harmonic termination circuitry according to some embodiments of the present disclosure, while FIGS. 8C and 8D are side views of example transistor amplifier packages including transistor dies with impedance adjustment elements 201 implemented by one or more conductive pillars 201" that extend external to the semiconductor structure 210 to provide input and/or output harmonic termination circuitry according to some embodiments of the present disclosure. In particular, FIGS. 8A and 8C illustrate open cavity-type packages 800a and 800c, where the transistor die(s) 300, 400, 500, 600, 700 or other internal components are protected by a lid member as a package housing that provides an open cavity around the internal components. FIGS. 8B and 8D illustrate overmold-type packages 800b and 800d, where the transistor die(s) 300, 400, 500, 600, 700 or other internal components are protected by a mold structure as a package housing that fills spaces between the internal components. The packages 800a, 800b, 800c, 800d of FIGS. 8A, 8B, 8C, and 8D are illustrated with reference to the transistor die 300 of FIGS. 3A and 3B by way of example only, and it will be understood that any of the configurations of the transistor dies 300, 400, 500, 600, 700 described herein may be used with any package type, including but not limited to those shown in FIGS. 8A to 8D.

As shown in FIGS. 8A, 8B, 8C, and 8D, a package substrate 260 includes input RFin, output RFout, and ground GND terminals, and one or more transistor dies 300 on a surface of the package substrate 260. The package substrate 260 may be single- or multi-layer laminate (such as a single- or multi-layer printed circuit board (PCB)) that includes conductive wiring or connection patterns 262 (e.g., vias 262', interlayer wiring 262", traces 262'", etc.) (collectively referred to as conductive connection patterns 262) that are electrically connected to respective input, output, or ground contacts or connections 214, 234, 224 of the transistor die(s) 300 by conductive bumps or pillars. An underfill material 805 may provide attachment and/or mechanical support for the transistor die(s) 300, as well as mechanical stability in asymmetric configurations of the conductive pillars 201" described herein. In some embodiments, as shown in FIGS. 8C and 8D, the volume of the underfill material 805 between bottom surface of the transistor die(s) 300 and the package substrate 260 may be asymmetric, e.g., with a greater volume of underfill material 805 where fewer conductive pillars 201" are present. The multi-layer laminate 260 and conductive connection patterns 262 may be fabricated using semiconductor processing techniques by depositing conductive and insulating layers and/or patterns on a base material and by forming vias and conductive routing patterns within the structure. The conductive connection patterns 262 also couple the contacts or connections 214, 234, 224 of the transistor die(s) 300 to input RFin, output RFout, and ground GND terminals of the package substrate 260. In particular, the ground terminal GND of the package substrate 260 may be electrically coupled to the ground connection 224 of the transistor die(s) 300.

The RF input leads RFin and RF output leads RFout are configured for attachment and/or coupling to external devices, such as a customer circuit board. While illustrated in the figures as being provided on an opposite surface of the substrate 260 than the semiconductor structure 210, it will be understood that transistor amplifier packages as described herein are not limited to such an arrangement, and the RF input leads RFin and RF output leads RFout may be provided on the same surface of the substrate 260 as the semiconductor structure 210 in some embodiments.

The substrate 260 may provide a structural element or base on which the semiconductor structure 210 is attached or mounted. In the example packages 800a, 800b, 800c, 800d of FIGS. 8A, 8B, 8C, and 8D, the transistor die(s) 300 are illustrated as being mounted on the substrate 260 in a flip chip configuration, in which one or more of the input, output, and ground contacts or connections 214, 224, 234 are provided on one surface of the semiconductor structure 210, which is mounted face-down on the substrate 260 such that the connections 214, 224, and/or 234 are coupled to conductive connection patterns 262 by conductive bumps or pillars. However, it will be understood that embodiments of the present disclosure are not limited to transistor dies 300 mounted in flip chip configurations, and may include any configuration with impedance adjustment element(s) 201 (such as TSVs or TSiC vias) that are arranged or otherwise configured to provide input and/or output impedance control, e.g., for harmonic termination at one or more harmonic frequencies of a desired operating frequency or range and/or for impedance matching at the desired operating frequency or range as described herein.

Still referring to FIGS. 8A, 8B, 8C, and 8D, the packages 800a, 800b, 800c, 800d may include the semiconductor structure 210 of the one or more transistor dies 300 as well impedance matching circuits, phase delay elements, and/or other circuit components that may be used to provide an RF power amplifier, which are sealed or otherwise protected in a package housing or other protective member 470a, 470b (collectively 470). For example, the protective member 470 may include a lid member 470a (e.g., a ceramic-based lid) that defines an open cavity around the package components (see FIGS. 8A and 8C), or an overmold member 470b (e.g., a polymer-based encapsulant) that encapsulates the package components (see FIGS. 8B and 8D). In some embodiments, the protective member 470 may be formed of a thermally conductive material and/or may include an opening therein for dissipating or otherwise transmitting heat outside of the package 800a, 800b, 800c, 800d.

The example packages 800a, 800b, 800c, 800d may also include a heat dissipating member 460 and/or 465 having a surface that is exposed by or in contact with the protective member 470. In the examples of FIGS. 8A, 8B, 8C, and 8D, the surface of the semiconductor structure 210 opposite to the package substrate 260 includes a thermal interface material (TIM) 460 thereon. The TIM 460 may be configured to transfer heat generated from the semiconductor structure 210 to a heat sink (shown as heat spreader 465 in FIGS. 8A and 8C). The TIM 460 may be electrically and thermally conducting, or thermally conducting but electrically insulating, and may define a thermal conduction path configured to dissipate heat from the "top" of the packages 800a, 800b, 800c, 800d. However it will be understood that the TIM 460, heat spreader 465, and/or protective member 470 may not be present in some embodiments.

The packages 800b and 800d of FIGS. 8B and 8D further include surface mount devices 815, 845 such as integrated passive devices (IPDs), that are configured to provide input and output impedance matching circuits. However, it will be understood that one or more components of the input and/or the output matching circuits may be implemented by distributed element structures within the layers of the substrate 260 of FIGS. 8A, 8B, 8C, and/or 8D in some embodiments. For example, the conductive connection patterns 262 and related structures in the multi-layer laminate 260 may electrically couple and/or may implement passive electrical components of one or impedance matching circuits coupled between the input terminal RFin and the gate contact 214, and/or between the drain contact 234 and the output terminal RFout. Other electrical components may also be implemented by the conductive connection patterns 262 in or on the substrate 260.

In some embodiments, the packages 800a, 800b, 800c, 800d may be free of harmonic termination circuit elements that are coupled to the input and/or output connections 214/234 of the transistor die(s). That is, the transistor die(s) may be configured to provide a series resonance or short circuit condition at the input and/or output connections 214/234 at one or more harmonic frequencies based entirely on the internal impedance adjustment elements 201, and free of contributions from harmonic termination circuit elements that are external to the semiconductor structure 210 of the die(s) 300.

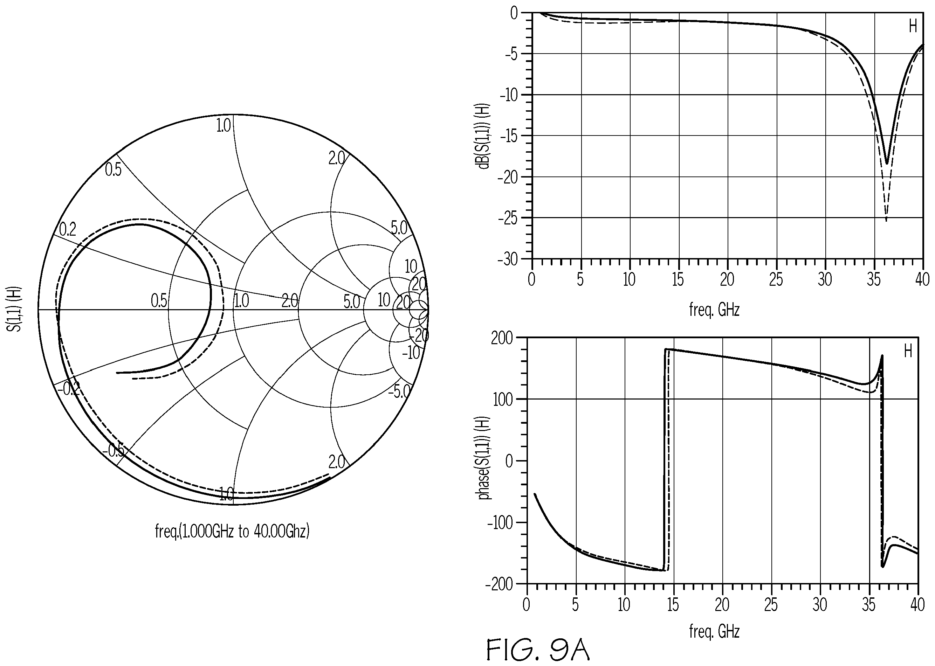

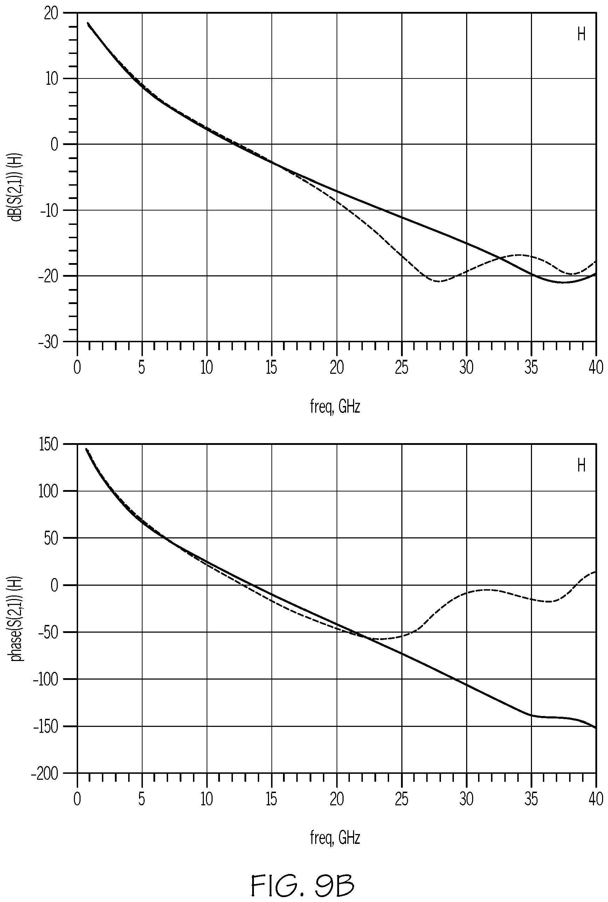

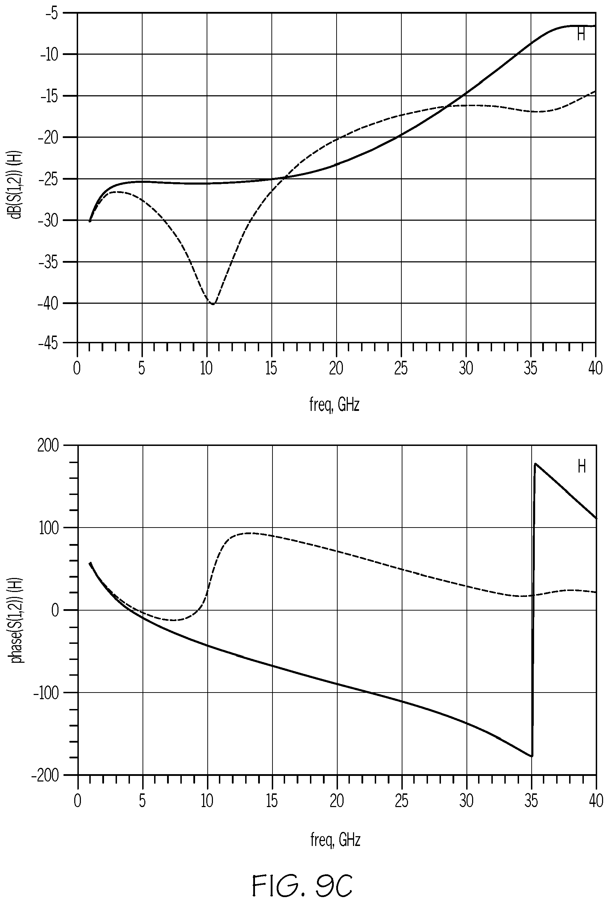

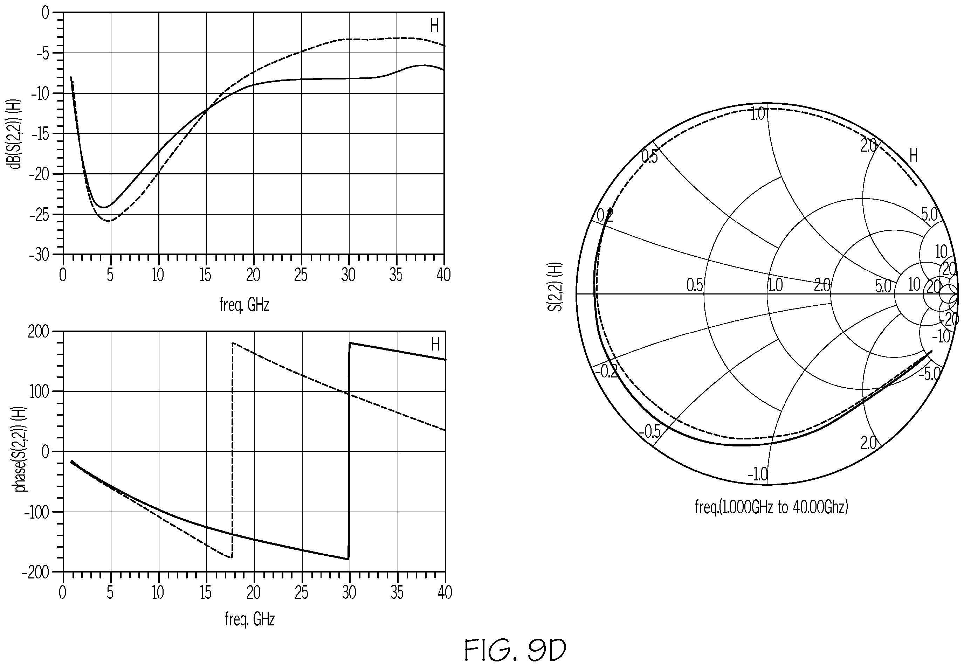

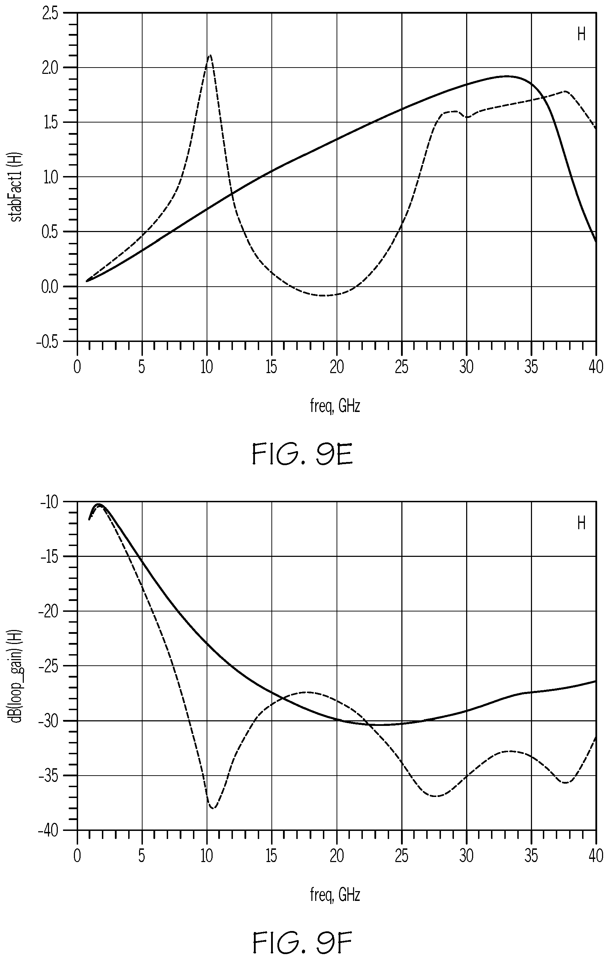

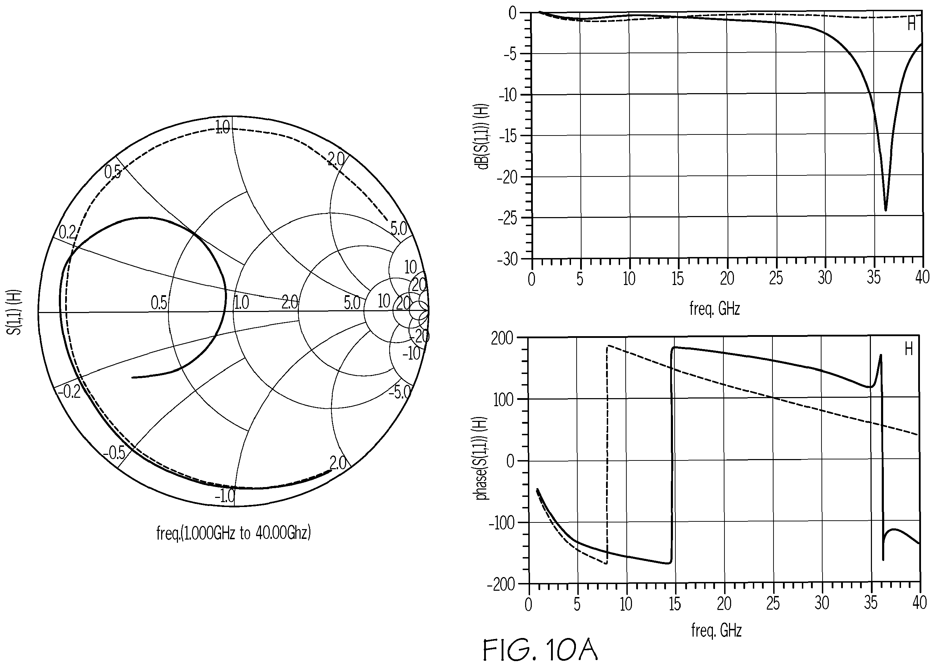

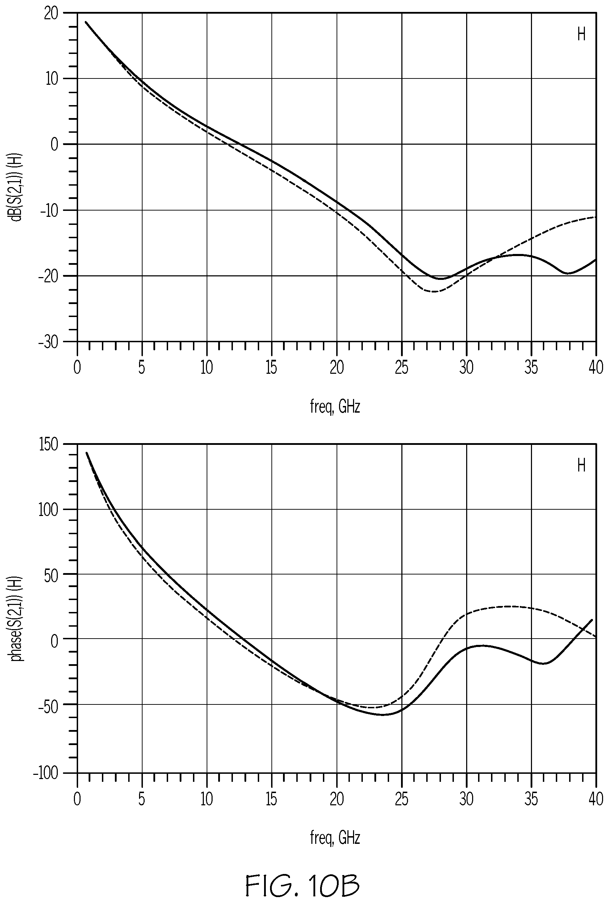

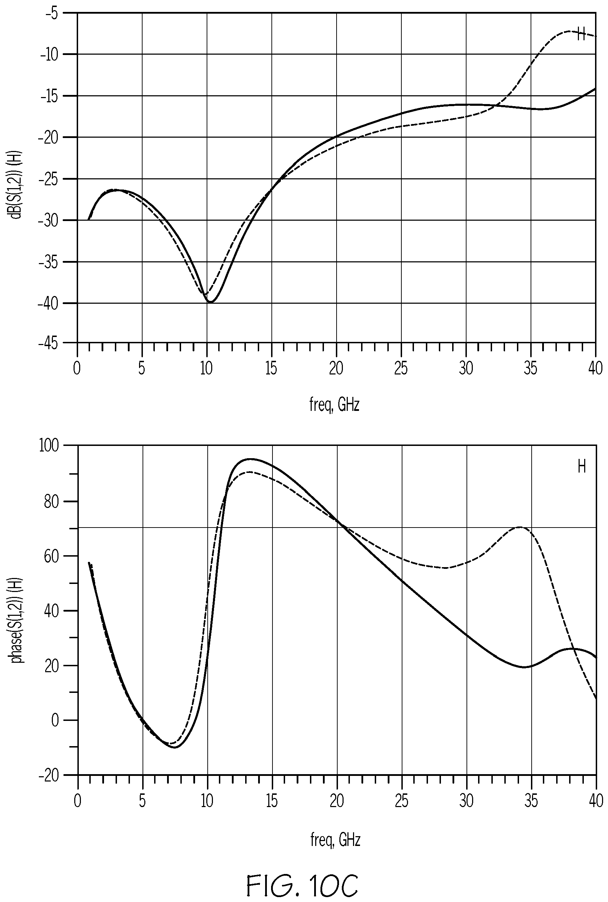

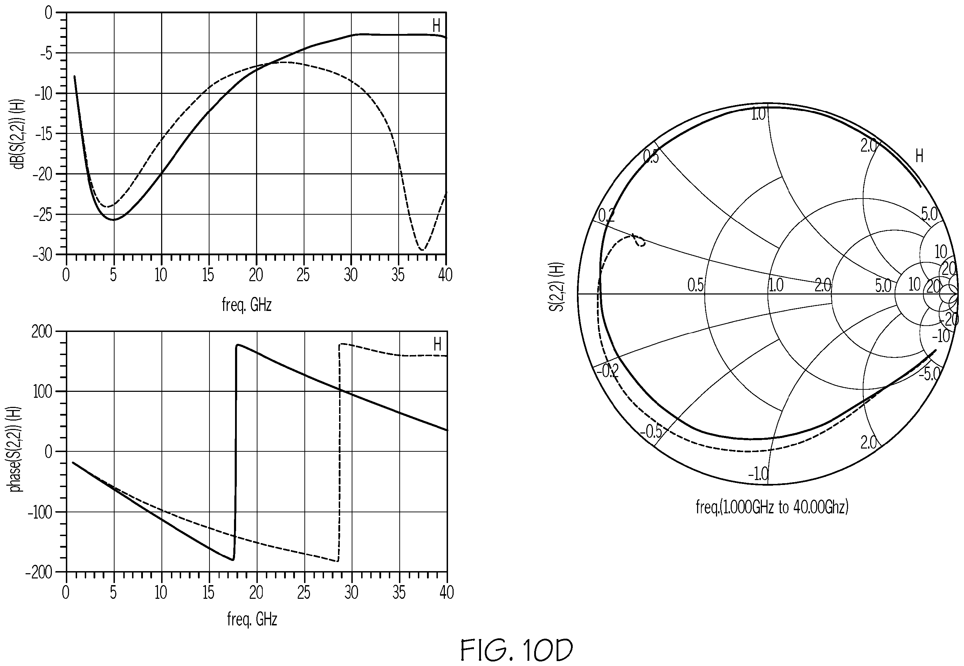

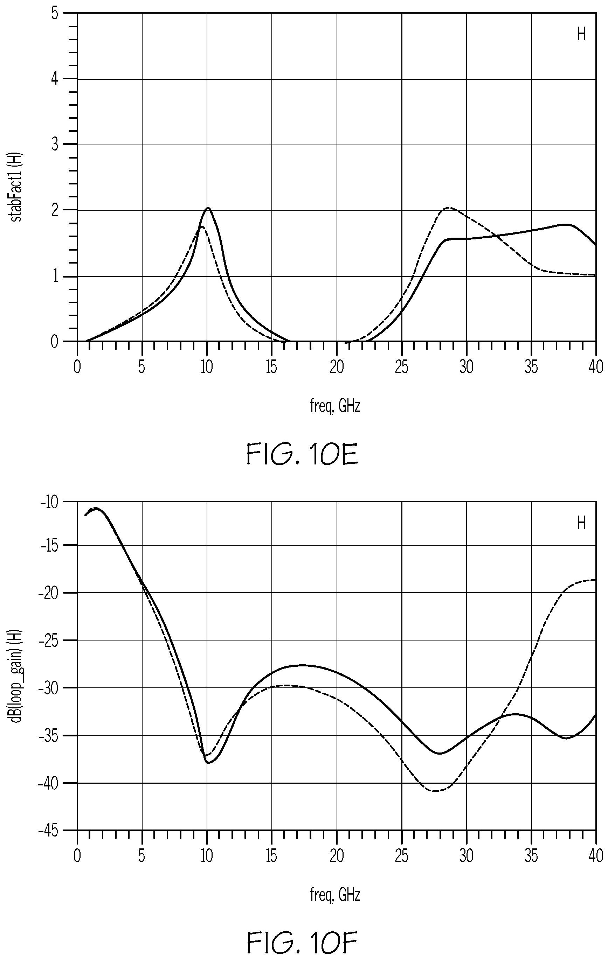

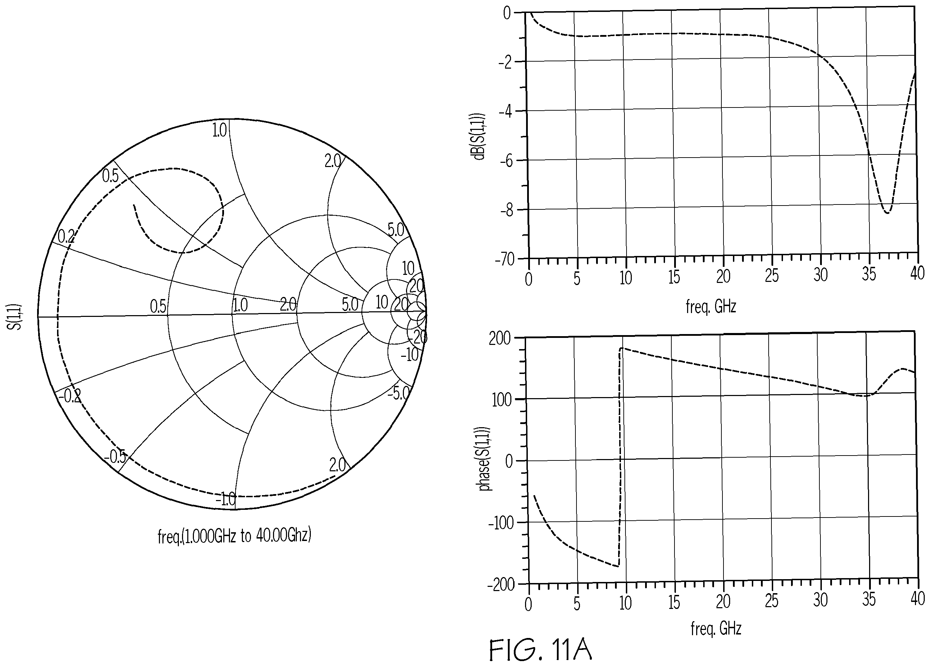

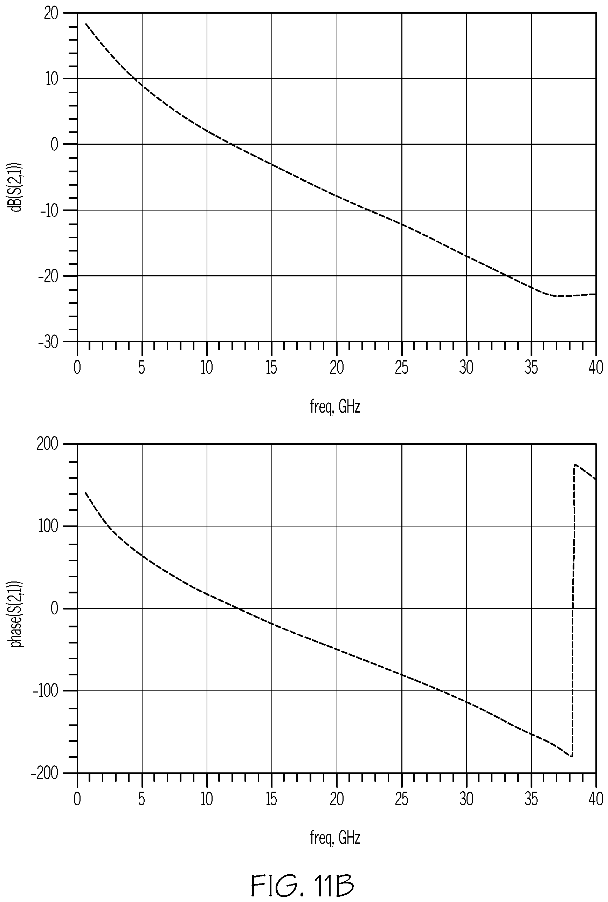

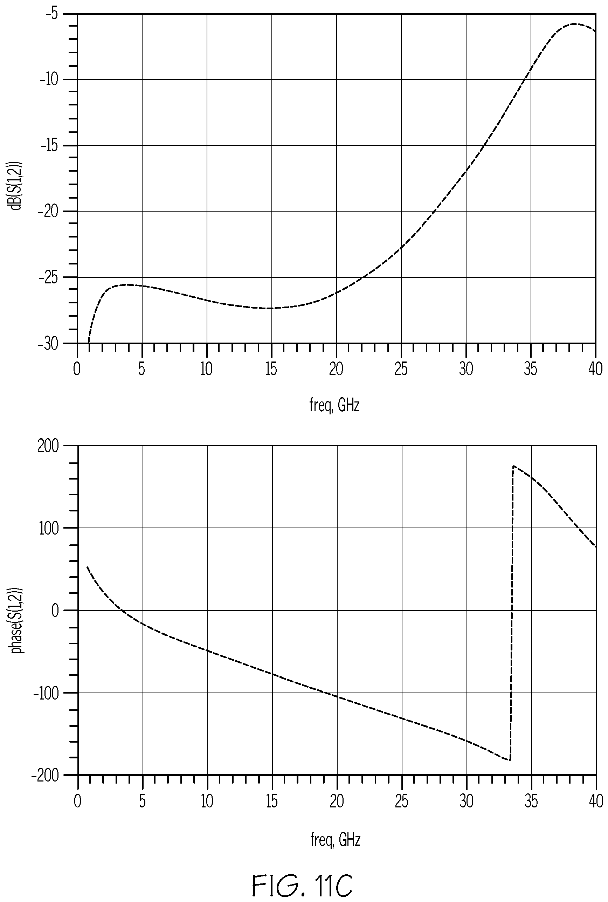

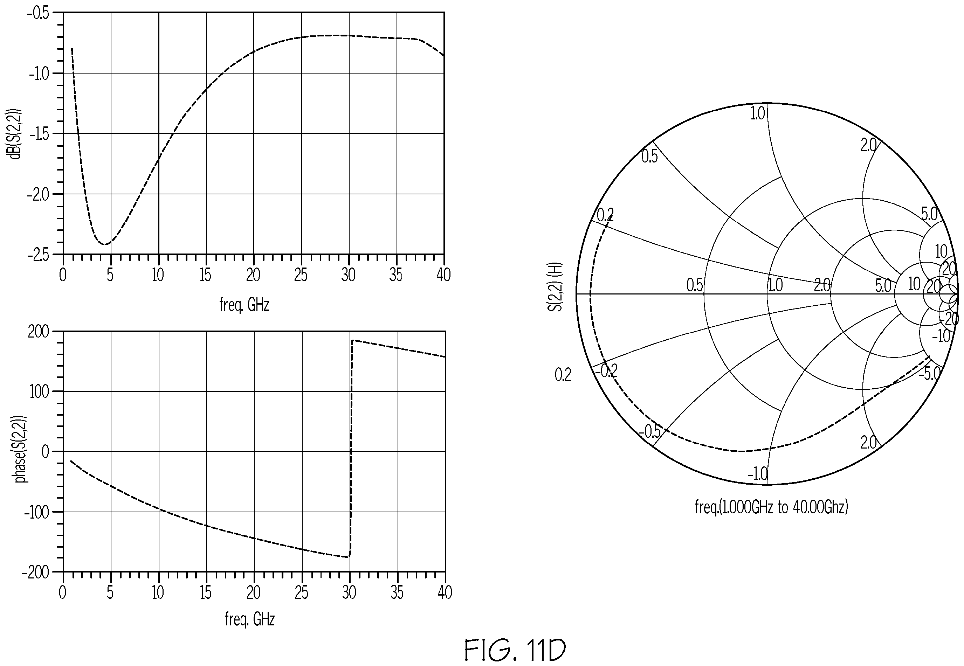

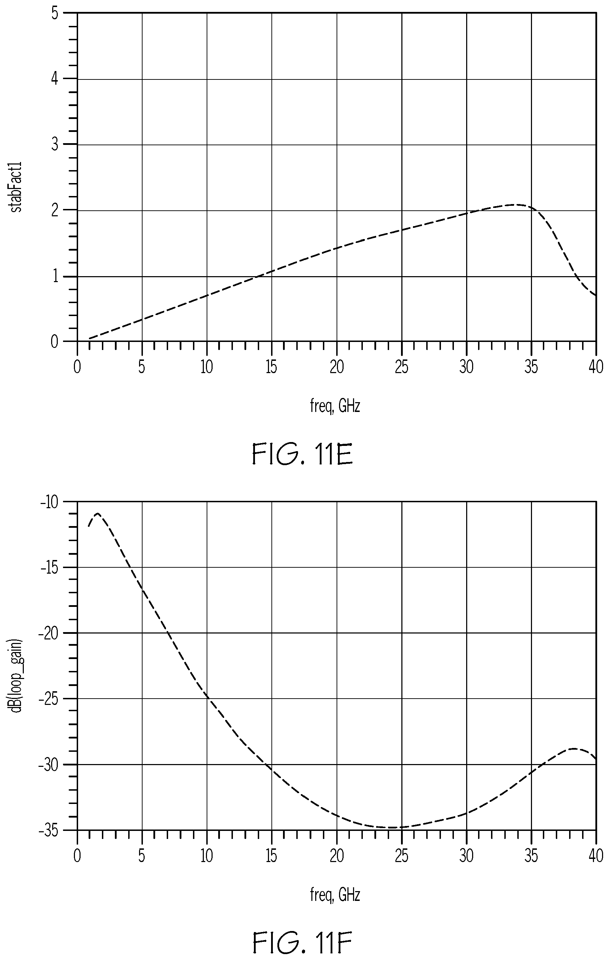

FIGS. 9A, 9B, 9C, 9D, 9E, and 9F are graphs illustrating effects of the impedance adjustment elements 201 of the transistor die 300 of FIGS. 3A and 3B (including gate-proximate conductive vias 201' on the respective source fingers 26) in comparison with providing conductive vias 201' at opposing edges of a source finger. FIGS. 10A, 10B, 10C, 10D, 10E, and 10F are graphs illustrating effects of the impedance adjustment elements 201 of the transistor die 400 of FIGS. 4A and 4B (including drain-proximate conductive vias 201' on respective source fingers 26) in comparison to the impedance adjustment elements 201 of the transistor die of FIGS. 3A and 3B. FIGS. 11A, 11B, 11C, 11D, 11E, and 11F are graphs illustrating effects of the impedance adjustment elements 201 of the transistor die 600 of FIGS. 6A and 6B (including centrally-positioned conductive vias 201' and drain-proximate conductive vias 201' on respective source fingers 26). The effects illustrated in the graphs of FIGS. 9, 10, and 11 are shown by way of example with reference to scattering parameters (s-parameters) indicating the input port voltage reflection coefficient (S11), output port voltage reflection coefficient (S22), forward voltage gain (S21), and reverse voltage gain (S 12), as well as stability factor (K factor) and loop gain.

As shown in FIGS. 9-11, adjusting the number of vias/pillars and the locations of the vias/pillars along the respective source fingers in accordance with embodiments of the present disclosure may impact stability (shown with reference to the stability factor K; see FIGS. 9E, 10E, and 11E. In particular, FIGS. 9-11 illustrate that the location of the vias 201' /pillars 201" (e.g., on the gate side or the drain side of the respective source fingers 26) influences the transistor impedances at particular harmonic frequencies. For example, the S22 plot in FIG. 9D shows effects on the output impedance at harmonic frequencies by providing a via 201'/pillar 201" on the gate-side (as shown by the dashed lines in FIGS. 9A-9F) of the respective source fingers 26, in comparison to providing two vias/pillars on the edges (as shown by the solid lines in FIGS. 9A-9F). The S11 and S22 plots of FIGS. 10A and 10D illustrate differences in input and output impedances at harmonic frequencies by providing a via 201'/pillar 201" on the drain-side of the respective source fingers 26 (as shown by the dashed lines in FIGS. 10A-10F), in comparison to providing a via 201'/pillar 201" on the gate-side (as shown by the solid lines in FIGS. 10A-10F). The S11 and S22 plots of FIGS. 11A and 11D illustrate that a transistor die 600 including centrally-positioned and drain-proximate conductive vias 201'/pillars 201" on respective source fingers 26 (with gate fingers 16 having a UGW of about 500 µm) may provide series resonance at the input connection 214 at a second harmonic frequency 2f0 of about 10 GHz, and series resonance at the output connection 234 at a third harmonic frequency 3f0 of about 15 GHz (for an operating frequency f0 of about 5 GHz).

FIGS. 9-11 thus illustrate significant influences on gate and drain impedances that may be achieved by impedance adjustment elements 201 as described herein. In some embodiments, controlling the via/pillar location(s) on the source finger in combination with the UGW may be configured to achieve a short circuit condition at one or more harmonic frequencies may achieve an efficiency improvement of about 60% or more as compared to some conventional devices.

Further embodiments of the present disclosure may include impedance adjustment elements that are configured to improve the line up efficiency for multi-stage power amplifiers, such as MMIC-based and/or Doherty multi-stage amplifiers. For example, Doherty topologies may be used to achieve higher efficiency when amplifying linear signals (e.g., variable envelope). While attention may be directed towards the optimization of the transistor parameters with respect to drain efficiency and gain, the power amplifying function of the transmitter may not typically be realized with a single stage device, for example, in Doherty amplifiers that are used in communication systems. In particular, base station amplifiers may range between about 50 and 60dB; MIMO amplifiers may range about 50dB; portable power amplifiers may range about 30 to 40dB. In a multi-stage amplifier, the higher efficiency (e.g., about 55%) obtained on an output or final stage Doherty amplifier may be substantially reduced at the line up level, e.g., by about 10%. The main contributor to such reduced efficiency may be the input or driver stage, which may have significantly lower efficiency (e.g. about 10% to 15%).

Several factors may contribute to the relatively poor efficiency of the driver stage in a multi-stage amplifier, including the Doherty topology (e.g., in a single stage Doherty final or output stage with a driver input stage, or in a multi-stage main/multi-stage peak Doherty configuration) and the inter-stage matching network losses. In particular, the inter-stage matching losses may be attributable to a relatively low real part of the input/gate impedance (Re(Zgate)) of the final stage, which may lead to a very high transformation ratio between the output (e.g., the drain) of the driver transistor and the input (e.g., the gate) of the final stage, and the high quality factor (Q) of the final stage input/gate impedance (which may worsen the high transformation ratio). That is, one cause of efficiency decrease with respect to the final stage of a multi-stage amplifier may reside in the inter-stage matching loss, which may be caused by a large transformation ratio between the driver stage output impedance and the final stage input impedance, where the input impedance of the final stage may suffer from a very low real part Re(Zgate) and a very high quality factor Q.

As described above, control of source inductance using impedance adjustment elements 201 as described herein may be used to control input and/or output terminal impedances despite the source-connected elements 201 not being physically connected to the gate and/or drain connections. Accordingly, further embodiments may be directed to improving or optimizing the size, location/placement, and number of impedance adjustment elements 201 (including internal vias 201' and/or external conductive pillars 201") with respect to input and/or output impedance at fundamental operating frequency f0, for example for inter-stage impedance matching in a multi-stage amplifier. In particular, some embodiments of the present disclosure may affect both input impedance (Zgate) and quality factor (Q) by locating the source grounding connections 201 towards the drain side of a transistor die that provides the output stage in a multi-stage amplifier.

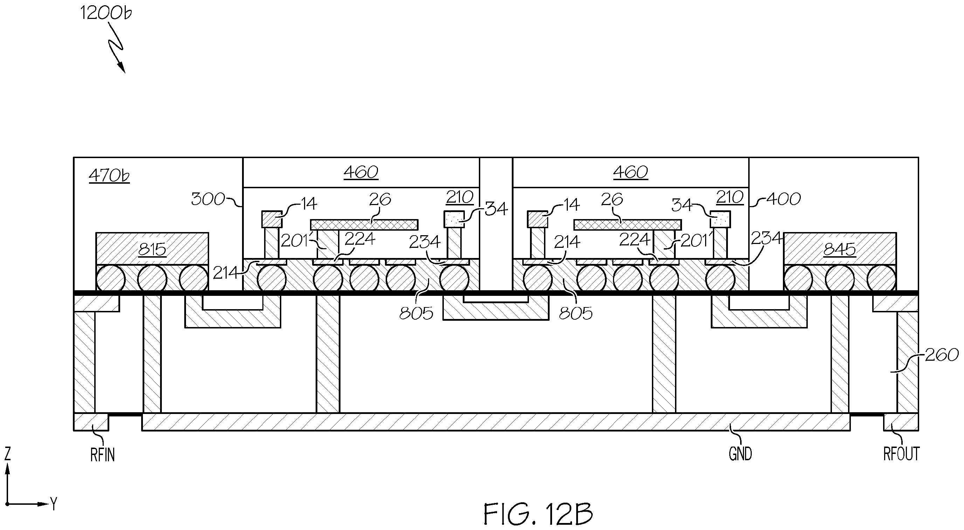

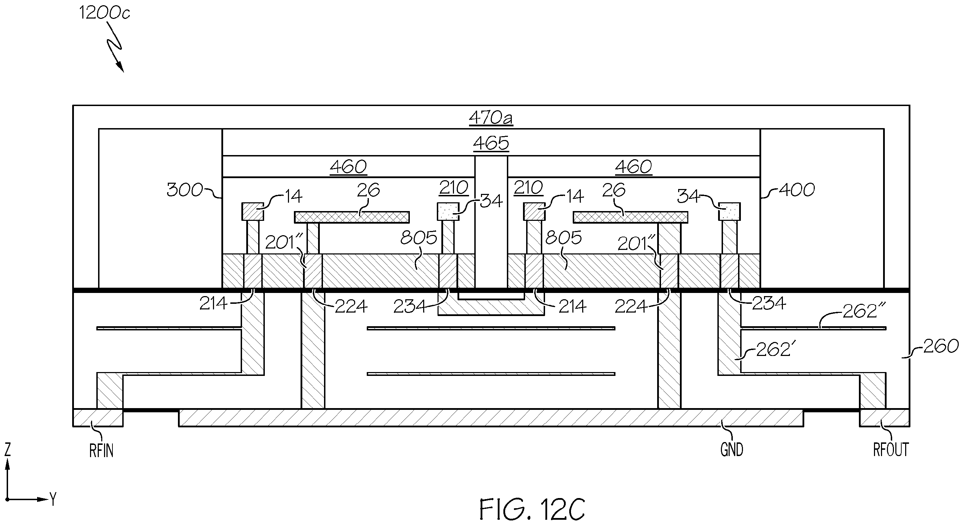

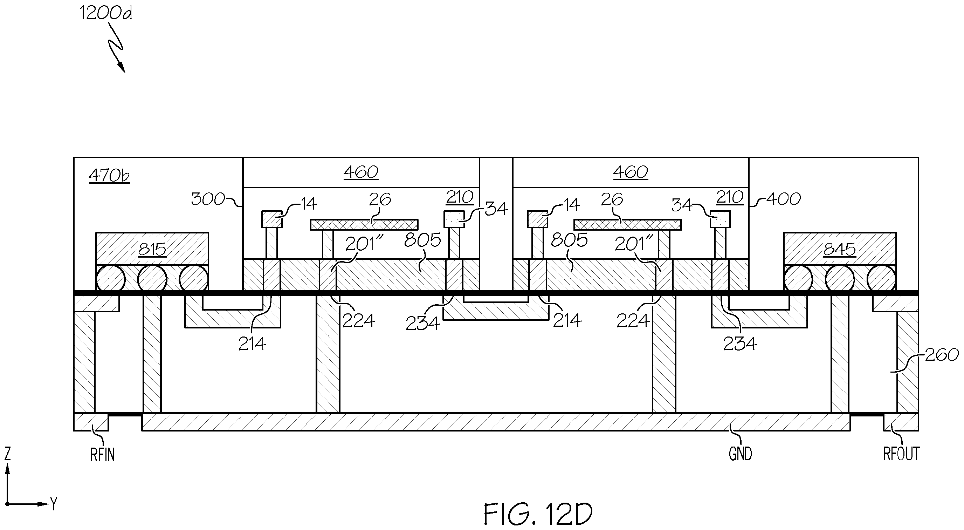

FIGS. 12A and 12B are side views of example transistor amplifier packages including transistor dies with on-die impedance adjustment elements 201 implemented by one or more conductive vias 201' that are internal to the semiconductor structure 210 to provide inter-stage impedance matching circuitry according to some embodiments of the present disclosure, while FIGS. 12C and 12D are side views of example transistor amplifier packages including transistor dies with on-die impedance adjustment elements 201 implemented by one or more conductive pillars 201" that extend external to the semiconductor structure 210 to provide inter-stage impedance matching circuitry according to some embodiments of the present disclosure. In particular, FIGS. 12A and 12C illustrate open cavity-type packages 1200a and 1200c, where the transistor die(s) 300, 400, 500, 600, 700 or other internal components are protected by a lid member as a package housing that provides an open cavity around the internal components. FIGS. 12B and 12D illustrate overmold-type packages 1200b and 1200d, where the transistor die(s) 300, 400, 500, 600, 700 or other internal components are protected by a mold structure as a package housing that fills spaces between the internal components. The packages 1200a, 1200b, 1200c, 1200d of FIGS. 12A, 12B, 12C, and 12D are illustrated with reference to the transistor die 300 of FIGS. 3A and 3B as the input stage and with reference to the transistor die 400 of FIGS. 4A and 4B as the output stage of the illustrated multi-stage amplifiers by way of example only, and multi-stage amplifier embodiments described herein are not limited to the transistor dies 300, 400 shown. Also, it will be understood that any of the configurations of the transistor dies 300, 400, 500, 600, 700 described herein may be used with any package type, including but not limited to those shown in FIGS. 12A to 12D.

As shown in FIGS. 12A, 12B, 12C, and 12D, a package substrate 260 includes input RFin, output RFout, and ground GND terminals, and first and second transistor dies 300 and 400 in a multi-stage arrangement on a surface of the package substrate 260. The first transistor die 300 may implement a driver or input stage of a multi-stage amplifier. The second transistor die 400 may implement a final or output stage of the multi-stage amplifier, where the input connection 214 of the second transistor die 400 is coupled to the output connection 234 of the first transistor die 300. The packages 1200a-1200d may be configured to implement any number of multi-stage amplifier configurations, including but not limited to an input driver with single stage Doherty output, or a multi-stage main and multi-stage peaking Doherty amplifier configuration.

The package substrate 260 may be a single- or multi-layer laminate (such as a single- or multi-layer printed circuit board (PCB)) that includes conductive wiring or connection patterns 262 (e.g., vias 262', interlayer wiring 262", traces 262"', etc.) (collectively referred to as conductive connection patterns 262) that are electrically connected to respective input, output, or ground contacts or connections 214, 234, 224 of the transistor die(s) 300 and 400 by conductive bumps or pillars, as described above with reference to FIGS. 8A to 8D. Description of elements similar or corresponding to those described above with reference to FIGS. 8A to 8D are omitted for brevity. While the transistor dies 300 and 400 are illustrated as being mounted on the substrate 260 in a flip chip configuration, it will be understood that embodiments of the present disclosure are not limited to transistor dies 300, 400 mounted in flip chip configurations, and may include any configuration with impedance adjustment element(s) 201 (such as TSVs or TSiC vias) that are arranged or otherwise configured to provide input and/or output impedance control, e.g., for harmonic termination at one or more harmonic frequencies of a desired operating frequency or range and/or for impedance matching at the desired operating frequency or range as described herein.

The packages 1200b and 1200d of FIGS. 12B and 12D further include surface mount devices 815, 845 such as integrated passive devices (IPDs), that are configured to provide input and output impedance matching circuits. However, it will be understood that one or more additional components of the input and/or the output matching circuits may be implemented by distributed element structures within the layers of the substrate 260 of FIGS. 12A, 12B, 12C, and/or 12D in some embodiments.

Still referring to FIGS. 12A to 12D, the on-die impedance adjustment elements 201 of the first die 300 and/or the second die 400 may be configured to reduce inter-stage matching losses between the output connection 234 of the first die 300 and the input connection 214 of the second die 400. As similarly discussed above, the impedance adjustment element(s) 201 may provide tuning elements or "knobs" that can be configured to adjust or otherwise control the input and/or output impedance seen at the input and/or output connections 214/234 of the transistor dies 300, 400 based on electrical coupling to the ground connection 224 (in particular, to the source fingers 26 of the transistors 300, 400). The impedance adjustment element(s) 201 may thereby be configured to provide input and/or output impedance matching at the RF operating frequency or frequency range of a RF transistor amplifier, even though the impedance adjustment elements 201 may not be directly or physically connected to the input and/or output connections 214/234 of the transistors 300, 400.

In particular, the impedance adjustment elements 201 may be configured to provide impedance matching at the input and/or output connections 214/234 at the fundamental operating frequency f0 based on a number or quantity of the conductive vias 201'/pillars 201", and the respective locations and/or spacings of the conductive vias 201'/pillars 201" (relative to the gate input or the drain output) on a respective source finger 26. For example, referring again to FIGS. 4A and 4B, the input impedance of the second transistor die 400 may be adjusted based on the distance between the drain bus 34 and the nearest conductive via 201' or pillar 201" on a respective source finger 26. In particular, in some embodiments, providing a conductive via 201' or pillar 201" on a respective source finger 26 in close proximity to the drain bus 34 may achieve an input impedance that provides a matching condition with respect to the output connection 234 of a first transistor die 300 at the fundamental operating frequency f0 of a multi-stage transistor amplifier. In some embodiments, a single via 201' or pillar 201" on a respective gate finger 26 in close proximity to the drain bus 34 or on the drain side of the second transistor die 400 (i.e., free of other vias 201'/pillars 201" on the respective gate finger 26) may increase the real part of the input impedance (Re(Zgate)) at the fundamental operating frequency f0, and may decrease quality factor (Q).

More generally, the position/number of conductive vias 201' and/or pillars 201" on the source fingers 26 (e.g., relative to the gate bus 14 or drain bus 34) may provide tuning elements for adjusting the impedance at the input and/or output connections 214/234. Accordingly, based on the desired operating frequency range of a transistor amplifier package, one or more transistor dies 300, 400 may be provided with impedance adjustment elements 201 on respective source fingers 26 so as to provide desired or predetermined input and/or output impedance values that achieve impedance matching at the input and/or output connections 214/234.

The on-die impedance adjustment elements 201 may thereby reduce the need for impedance matching circuit elements that are external to the dies 300, 400, particularly between a driver stage and an output stage of a multi-stage amplifier. In some embodiments, the packages 1200a, 1200b, 1200c, 1200d may be free of inter-stage impedance matching circuit elements that are coupled between the output connections 234 of the first transistor die 300 and the input connections 214 of the second transistor die 400. That is, the transistor dies 300 and/or 400 may be configured to provide inter-stage impedance matching at the fundamental frequency f0 based entirely on the on-die impedance adjustment elements 201, without impedance matching circuit elements that are external to the transistor dies 300, 400, depending on the operating frequency band and application (e.g., in some monolithic microwave integrated circuit (MMIC)-type applications). The impedance adjustment elements 201 may thus be configured to improve inter-stage impedance matching and provide high efficiency, multi-stage power amplifiers.

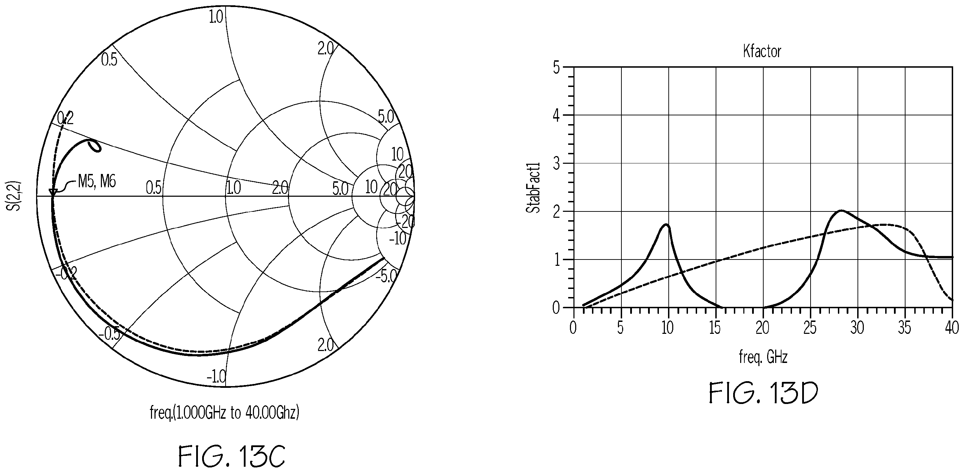

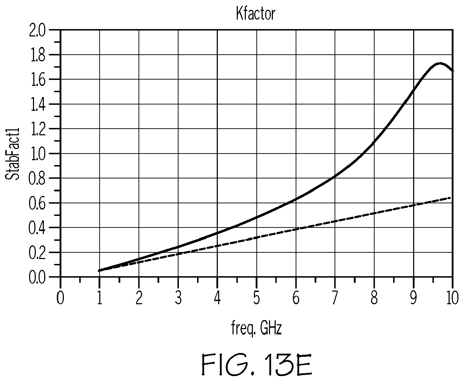

FIGS. 13A, 13B, 13C, 13D, and 13E are graphs illustrating effects of the impedance adjustment elements 201 of the transistor die 400 of FIGS. 4A and 4B (including one drain-proximate conductive via 201' and/or pillar 201" on a respective source finger 26; shown with solid lines) in comparison with providing three conductive vias symmetrically arranged or evenly-spaced along each source finger 26 (shown with dashed lines). The effects illustrated in the graphs of FIGS. 13A to 13E are shown by way of example with reference to scattering parameters (s-parameters) indicating the input port voltage reflection coefficient (S 11) in FIG. 13A, forward voltage gain (S21) in FIG. 13B, output port voltage reflection coefficient (S22) in FIG. 13C, and stability factor (K factor) in FIG. 13D. FIG. 13E illustrates an enlarged view of a frequency band of interest for the stability factor K.

In particular, FIGS. 13A to 13E illustrate that, at the fundamental frequency f0, providing the vias 201'/pillars 201" proximate the drain side of the respective source fingers 26 may impact the input impedance and stability, without substantially affecting the output impedance or gain. For example, in FIG. 13A, M1 and M2 show that, at an operating frequency f0 = 3.5GHz, the real part of the input impedance Re(Zgate) is increased by approximately two times, while the quality factor of the input impedance Q(Zgate) has a ratio of about 12/5 (in comparison to providing three evenly-spaced conductive vias along each source finger 26). M3 and M4 show that a significant decrease of the input impedance resonant frequency may be linked to the source inductance increase provided by the vias 201'/pillars 201" proximate the drain side of the respective source fingers 26. However, FIG. 13C illustrates that the output impedance (e.g., at M5 and M6) is substantially unchanged. Likewise, FIG. 13B illustrates that the forward voltage gain S21 is substantially unchanged at frequencies up to about 10GHz. As shown in FIGS. 13D and 13E, stability is much improved in the illustrated band of interest (e.g., up to about 10GHz), as shown by the significant increase in stability factor K. This increased stability may be directly attributed to the reduction in inter-stage matching losses as achieved by providing the vias 201'/pillars 201" proximate the drain side of the respective source fingers 26.

As described herein, embodiments of the present disclosure have recognized that grounding of the source of a FET transistor can be used to control multiple transistor characteristics, including not only the stability factor K, but also input and output impedances. In particular, the grounding of the source may at least partially define the gate return path (and likewise, the drain return path), in contrast with some representations of the grounding path in some conventional circuit models. In other words, embodiments of the present disclosure may arise from recognition that the configuration of ground-connected elements, which are internal to and/or extend external to the die, may be used to control input and/or output harmonic products, despite the ground-connected elements not being physically connected to the input and/or output connections in some embodiments.

As such, some embodiments of the present disclosure provide impedance adjustment elements of various configurations that can be used to tailor or tune a ground source inductance to provide input and/or output harmonic termination circuitry, in some instances with the transistor die in a flip chip configuration. In contrast, in some conventional RF power devices, the source of the device is typically grounded using through semiconductor vias without regard to the effects on the gate return path and/or drain return path, let alone to adjust impedance contributions to input and/or output harmonic termination (e.g., based on number, location, spacing, and/or UGW) as achieved by embodiments of the present disclosure.

In some embodiments, controlling the number/locations/spacing of source-connected external conductive pillars/internal vias on the source fingers 26, and/or the UGW, can be used to implement an input and/or output impedance (at the gate and/or drain, respectively) that provides a short circuit condition at one or more harmonic frequencies (e.g., at 2f₀, 3f₀) of a specific/desired operating frequency (f₀). In some embodiments, such a series resonance or short circuit condition may be achieved without coupling external harmonic termination circuit elements to the gate or drain contacts.

In addition, some embodiments may improve the fundamental input impedance of a RF transistor die (such as a GaN and/or SiC-based FET) by selecting the number and location of the internal source grounding conductive vias and/or externally extending conductive pillars, both for through-via and flip chip connections. Such configurations may have a positive influence in the line up efficiency, particularly in Doherty amplifier line up where efficiency may be a prime target. In some instances, a single source grounding connection (including an internal conductive via and/or external conductive pillar) placed in close proximity to the drain side of a transistor die may achieve an input impedance that is sufficient for impedance matching to the output of a driver transistor die in a multi-stage amplifier. More generally, some embodiments of the present disclosure may provide controlled grounding of the source using on-die impedance adjustment elements that are configured to improve or optimize the input and/or output impedance of the transistor at the fundamental operating frequency, which may benefit multi-stage efficiency and/or RF bandwidth (RFBW).

Embodiments of the present disclosure may thereby implement grounding path division and control to achieve several performance improvements, including (but not limited to) broader operating bandwidth, input impedance control (e.g., at f0, 2f0), and/or output impedance control (e.g., at 2f0 or 3f0). Additional advantages may also include (but are not limited to) higher efficiency (e.g., in the bandwidth around f0), more compact design (as there may be no need to utilize the matching network elements that are external to the transistor die to provide impedance matching and/or harmonic control), and fewer components. The use of intrinsic capacitances as provided by on-die impedance adjustment elements as described herein (rather than external resonator circuits) may also allow for broader harmonic control, as the capacitance provided by external resonator circuits may not exceed a fraction of the intrinsic capacitances (Cgs/Cds) Embodiments of the present disclosure may offer further design freedom in flip-chip configurations and/or in non-flip chip configurations (e.g., with through-SiC vias) to implement source inductance control.

Some embodiments of in-die or internal source impedance adjustment configurations described herein may be used in combination with off-die or external source impedance adjustment configurations as described for example in European Patent Application No. 22306636.6, filed October 28, 2022 (Attorney Docket No. 5308.3294.EP; incorporated by reference herein), to improve both efficiency and stability (e.g., with respect to stability factor K). Some embodiments may also include one or more thermal/heat dissipation paths (e.g., at the "top" side (which is opposite the gate, drain, and source contacts in a flip chip configuration) and/or the "bottom" side (which includes the gate, drain, and source contacts in a flip chip configuration) thereby improving thermal performance.

Embodiments of the present disclosure may be used in various RF or microwave power amplifier applications, including civilian telecommunication or cellular infrastructure (CIFR) RF power products (including, but not limited to 5W, 10W, 20W, 40W, 60W, 80W and different frequency bands) e.g., for 5G and base station applications, as well as for radar and monolithic microwave integrated circuit (MMIC)-type applications, as well as other A/D applications.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises" "comprising," "includes" and/or "including" when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms used herein should be interpreted as having a meaning that is consistent with their meaning in the context of this specification and the relevant art and will not be interpreted in an idealized or overly formal sense unless expressly so defined herein.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "lateral" or "vertical" may be used herein to describe a relationship of one element, layer or region to another element, layer or region as illustrated in the figures. It will be understood that these terms are intended to encompass different orientations of the device in addition to the orientation depicted in the figures.

Embodiments of the invention are described herein with reference to cross-section illustrations that are schematic illustrations of idealized embodiments (and intermediate structures) of the invention. The thickness of layers and regions in the drawings may be exaggerated for clarity. Additionally, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Elements illustrated by dotted lines may be optional in the embodiments illustrated.

Like numbers refer to like elements throughout. Thus, the same or similar numbers may be described with reference to other drawings even if they are neither mentioned nor described in the corresponding drawing. Also, elements that are not denoted by reference numbers may be described with reference to other drawings.

In the drawings and specification, there have been disclosed typical embodiments of the invention and, although specific terms are employed, they are used in a generic and descriptive sense only and not for purposes of limitation, the scope of the invention being set forth in the following claims.

## Claims

1. A radio frequency (RF) transistor amplifier, comprising:
a transistor die comprising a semiconductor structure including a plurality of transistors and input, output, and ground connections electrically coupled thereto,
wherein the transistor die comprises one or more impedance adjustment elements that are on or internal to the semiconductor structure, are electrically coupled to the ground connection, and are configured to provide impedance matching and/or harmonic termination at the input and/or output connections at an operating frequency of the RF transistor amplifier.

2. The RF transistor amplifier of Claim 1, wherein the plurality of transistors comprise gate, drain, and source fingers that are electrically coupled to the input, output, and ground connections, respectively, and the one or more impedance adjustment elements comprise one or more conductive vias on a respective source finger.

3. The RF transistor amplifier of Claim 2, wherein:
the transistor die further comprises a gate bus that electrically couples the gate fingers, and a drain bus that electrically couples the drain fingers; and
the one or more conductive vias comprise at least one first via proximate the gate bus and configured to provide the harmonic termination at the input connection, and/or at least one second via proximate the drain bus and configured to provide the harmonic termination at the output connection.

4. The RF transistor amplifier of Claim 3, wherein the one or more impedance adjustment elements are configured to provide the harmonic termination at the input and/or output connections based on at least one of:
a quantity of the one or more conductive vias on the respective source finger;
respective locations of the one or more conductive vias on the respective source finger, relative to the gate bus or the drain bus; or
a unit gate width of the gate fingers.

5. The RF transistor amplifier of any of Claims 1 to 4, wherein the one or more impedance adjustment elements are configured to provide a short circuit condition at the input connection and/or at the output connection of the transistor die at one or more harmonic frequencies of the operating frequency.

6. The RF transistor amplifier of Claim 5, wherein the one or more impedance adjustment elements are configured to provide the short circuit condition at the input connection at a second harmonic frequency of the operating frequency, and are configured to provide the short circuit condition at the output connection at a third harmonic frequency of the operating frequency; and/or.
wherein the one or more impedance adjustment elements are configured to provide the short circuit condition free of contributions from harmonic termination circuit elements that are external to the semiconductor structure of the transistor die.

7. The RF transistor amplifier of Claim 1, wherein the one or more impedance adjustment elements are not connected to the input and/or output connections.

8. The RF transistor amplifier of any preceding Claim, further comprising:
a package substrate comprising input, output, and ground terminals,
wherein the transistor die is on the package substrate and the ground terminal of the package substrate is electrically coupled to the ground connection of the transistor die.

9. The RF transistor amplifier of Claim 8, wherein the transistor die is mounted on a surface of the package substrate in a flip chip configuration with the input, output, and ground connections adjacent the surface of the package substrate.

10. The RF transistor amplifier of Claim 8, wherein the package substrate is free of harmonic termination circuit elements that are coupled to the input and/or output connections.

11. The RF transistor amplifier of Claim 2 or any of Claims 3 to 10 when dependent on Claim 2, wherein a unit gate width of the gate fingers is based on the operating frequency.

12. The RF transistor amplifier of any preceding Claim, wherein the operating frequency is below about 12 GHz, or is below about 6 GHz.

13. The RF transistor amplifier of any preceding Claim, wherein the semiconductor structure comprises gallium nitride and/or silicon carbide.

14. A method of fabricating a radio frequency (RF) transistor amplifier, the method comprising:
providing a semiconductor structure including a plurality of transistors; and
providing one or more impedance adjustment elements in or on the semiconductor structure, wherein the one or more impedance adjustment elements are electrically coupled to a ground connection and are configured to provide impedance matching and/or harmonic termination at input and/or output connections at an operating frequency of the RF transistor amplifier.

15. The method of claim 14, wherein the RF transistor amplifier is further provided with the features of any one of claims 1 to 13.
